# FASCICULE DE BREVET EUROPEEN

(11) **EP 3 602 207 B1**
(45) Date de publication et mention de la délivrance du brevet: **30.12.2020**
(21) Numéro de dépôt: 18710881.6
(22) Date de dépôt: 16.03.2018
(51) Int. Cl.: G04C 3/04, G04C 13/02, G04B 19/26, G04B 17/26

(54) **PIÈCE D'HORLOGERIE COMPRENANT UN MOUVEMENT MÉCANIQUE DONT LA MARCHE EST AMÉLIORÉE PAR UN DISPOSITIF DE CORRECTION**
UHR, DIE EIN MECHANISCHES UHRWERK MIT VERBESSERTER GANGGENAUIGKEIT DURCH EINE KORREKTURVORRICHTUNG UMFASST
TIMEPIECE COMPRISING A MECHANICAL MOVEMENT OF WHICH THE OPERATION IS IMPROVED BY A CORRECTION DEVICE

(30) Priorité: 28.03.2017 EP 17163248; 23.05.2017 EP 17172489
(43) Date de publication de la demande: 05.02.2020
(73) Titulaire: The Swatch Group Research and Development Ltd, 2074 Marin (CH)
(72) Inventeur: TOMBEZ, Lionel, 2022 Bevaix (CH)
(74) Mandataire: ICB SA
(86) Numéro de dépôt international: PCT/EP2018/056726
(87) Numéro de publication internationale: WO 2018/177779

(56) Documents cités:
- EP-A1- 1 241 538
- EP-A1- 2 908 187
- WO-A2-2015/140332
- FR-A- 833 085
- FR-A1- 2 162 404

## Description

### Domaine technique

La présente invention concerne une pièce d'horlogerie comprenant un mouvement mécanique dont la marche est améliorée par un dispositif de correction d'une dérive temporelle éventuelle dans le fonctionnement de l'oscillateur mécanique qui cadence la marche du mouvement mécanique. Une telle dérive temporelle intervient notamment lorsque la période d'oscillation naturelle moyenne de l'oscillateur mécanique n'est pas égale à une période de consigne. Cette période de consigne est déterminée par un oscillateur auxiliaire qui est associé au dispositif de correction.

En particulier, la pièce d'horlogerie est formée, d'une part, par un mouvement mécanique comprenant :
- un mécanisme indicateur d'au moins une donnée temporelle,
- un résonateur mécanique susceptible d'osciller le long d'un axe général d'oscillation autour d'une position neutre correspondant à son état d'énergie potentielle minimale,
- un dispositif d'entretien du résonateur mécanique formant avec ce dernier un oscillateur mécanique qui est agencé pour cadencer la marche du mécanisme indicateur, chaque oscillation de cet oscillateur mécanique définissant une période d'oscillation,
et, d'autre part, par un dispositif de régulation de la fréquence moyenne de l'oscillateur mécanique pour améliorer la marche de la pièce d'horlogerie.

### Arrière-plan technologique

Des pièces d'horlogerie telles que définies dans le domaine de l'invention ont été proposées dans quelques documents antérieurs. Le brevet CH 597 636, publié en 1977, propose une telle pièce d'horlogerie en référence à sa figure 3. Le mouvement est équipé d'un résonateur formé par un balancier-spiral et d'un dispositif d'entretien classique comprenant une ancre et une roue d'échappement en liaison cinématique avec un barillet muni d'un ressort. Ce mouvement horloger comprend en outre un dispositif de régulation de la fréquence de son oscillateur mécanique. Ce dispositif de régulation comprend un circuit électronique et un ensemble magnétique formé d'une bobine plate, agencée sur un support sous la serge du balancier, et de deux aimants montés sur le balancier et agencés proches l'un de l'autre de manière à passer tous deux au-dessus de la bobine lorsque l'oscillateur est activé.

Le circuit électronique comprend une base de temps comprenant un résonateur à quartz et servant à générer un signal de fréquence de référence FR, cette fréquence de référence étant comparée avec la fréquence FG de l'oscillateur mécanique. La détection de la fréquence FG de l'oscillateur est réalisée via les signaux électriques générés dans la bobine par la paire d'aimants. Le circuit de régulation est agencé pour pouvoir engendrer momentanément un couple de freinage via un couplage magnétique aimant-bobine et une charge commutable reliée à la bobine.

L'utilisation d'un système électromagnétique du type aimant-bobine pour coupler le balancier-spiral avec le circuit électronique de régulation engendre divers problèmes. Premièrement, l'agencement d'aimants permanents sur le balancier a pour conséquence qu'un flux magnétique est constamment présent dans le mouvement horloger et que ce flux magnétique varie spatialement de manière périodique. Un tel flux magnétique peut avoir une action néfaste sur divers organes ou éléments du mouvement horloger, notamment sur des éléments en matériau magnétique comme des pièces en matériau ferromagnétique. Ceci peut avoir des répercussions sur le bon fonctionnement du mouvement horloger et également augmenter des usures d'éléments pivotés. On peut certes penser à blinder dans une certaine mesure le système magnétique en question, mais un blindage nécessite des éléments particuliers qui sont portés par le balancier. Un tel blindage tend à augmenter l'encombrement du résonateur mécanique et son poids. De plus, il limite les possibilités de configurations esthétiques pour le balancier-spiral.

L'homme du métier connaît aussi des mouvements mécaniques horlogers auxquels on associe un dispositif de régulation de la fréquence de leur balancier-spiral qui est du type électromécanique. Plus précisément, la régulation intervient via une interaction mécanique entre le balancier-spiral et le dispositif de régulation, ce dernier étant agencé pour agir sur le balancier oscillant par un système formé d'une butée agencée sur le balancier et d'un actuateur muni d'un doigt mobile qui est actionné à une fréquence de freinage en direction de la butée, sans toutefois toucher la serge du balancier. Une telle pièce d'horlogerie est décrite dans le document FR 2.162.404. Selon le concept proposé dans ce document, on vise à synchroniser la fréquence de l'oscillateur mécanique sur celle d'un oscillateur à quartz par une interaction entre le doigt et la butée lorsque l'oscillateur mécanique présente une dérive temporelle relativement à une fréquence de consigne, le doigt étant prévu pour pouvoir soit bloquer momentanément le balancier qui est alors stoppé dans son mouvement durant un certain intervalle de temps (la butée venant en appui contre le doigt déplacé dans sa direction lors d'un retour du balancier en direction de sa position neutre), soit limiter l'amplitude d'oscillation lorsque le doigt arrive contre la butée alors que le balancier tourne en direction d'une de ses deux positions angulaires extrêmes (définissant son amplitude), le doigt stoppant alors l'oscillation et le balancier repartant directement en sens inverse.

Un tel système de régulation présente de nombreux inconvénients et on peut sérieusement douter qu'il puisse former un système fonctionnel. L'actionnement périodique du doigt relativement au mouvement d'oscillation de la butée et également un déphasage initial potentiellement grand, pour l'oscillation de la butée par rapport au mouvement périodique du doigt en direction de cette butée, posent plusieurs problèmes. On remarquera que l'interaction entre le doigt et la butée est limitée à une seule position angulaire du balancier, cette position angulaire étant définie par la position angulaire de l'actionneur relativement à l'axe du balancier-spiral et la position angulaire de la butée sur le balancier au repos (définissant sa position neutre). En effet, le mouvement du doigt est prévu pour permettre d'arrêter le balancier par un contact avec la butée, mais le doigt est agencé pour ne pas venir en contact avec la serge du balancier. De plus, on notera que l'instant d'une interaction entre le doigt et la butée dépend aussi de l'amplitude de l'oscillation du balancier-spiral.

On remarquera que la synchronisation souhaitée paraît improbable. En effet, en particulier pour un balancier-spiral dont la fréquence est supérieure à la fréquence de consigne cadençant les va-et-vient du doigt et avec une première interaction entre le doigt et la butée qui retient momentanément le balancier revenant d'une de ses deux positions angulaires extrêmes (correction réduisant l'erreur), la deuxième interaction, après de nombreuses oscillations sans que la butée touche le doigt lors de son mouvement alternatif, sera certainement un arrêt du balancier par le doigt avec inversion immédiat de son sens d'oscillation, par le fait que la butée vient buter contre le doigt alors que le balancier tourne en direction de ladite position angulaire extrême (correction augmentant l'erreur). Ainsi, non seulement il y a une dérive temporelle non corrigée durant un intervalle de temps qui peut être long, par exemple de plusieurs centaines de périodes d'oscillation, mais certaines interactions entre le doigt et la butée augmentent la dérive temporelle au lieu de la réduire ! On remarquera encore que le déphasage de l'oscillation de la butée, et donc du balancier-spiral, lors de la deuxième interaction susmentionnée peut être important selon la position angulaire relative entre le doigt et la butée (balancier dans sa position neutre).

On peut ainsi douter que la synchronisation voulue soit obtenue. De plus, en particulier si la fréquence naturelle du balancier-spiral est proche mais non égale à la fréquence de consigne, des situations où le doigt est bloqué dans son mouvement en direction du balancier par la butée qui est située à cet instant en face du doigt sont prévisibles. De telles interactions parasites peuvent endommager l'oscillateur mécanique et/ou l'actuateur. De plus, ceci limite pratiquement l'étendue tangentielle du doigt. Finalement, la durée du maintien du doigt en position d'interaction avec la butée doit être relativement courte, limitant donc une correction engendrant un retard. En conclusion, le fonctionnement de la pièce d'horlogerie proposée dans le document FR 2.162.404 paraît à l'homme du métier hautement improbable, et il se détourne d'un tel enseignement.

### Résumé de l'invention

Un but de la présente invention est de trouver une solution aux problèmes techniques et inconvénients de l'art antérieur mentionnés dans l'arrière-plan technologique.

Dans le cadre de la présente invention, on cherche de manière générale à améliorer la précision de la marche d'un mouvement horloger mécanique, c'est-à-dire de diminuer la dérive temporelle journalière de ce mouvement mécanique. En particulier, la présente invention cherche à atteindre un tel but pour un mouvement horloger mécanique dont la marche est réglée initialement au mieux. En effet, un but général de l'invention est de trouver un dispositif pour prévenir une dérive temporelle potentielle d'un mouvement mécanique, à savoir un dispositif de régulation de sa marche pour augmenter sa précision, sans pour autant renoncer à ce qu'il puisse fonctionner de manière autonome avec la meilleure précision qu'il lui est possible d'avoir grâce à ses propres caractéristiques, c'est-à-dire en l'absence du dispositif de régulation ou lorsque ce dernier est inactif.

A cet effet, la présente invention concerne une pièce d'horlogerie telle que définie dans la revendication indépendante 1 annexée.

Dans une variante générale, le système formé du résonateur mécanique et du dispositif de freinage mécanique est configuré de manière que la plage de positions du résonateur mécanique, dans laquelle peuvent débuter les impulsions de freinage périodiques, s'étend également du second des deux côtés de la position neutre du résonateur mécanique sur au moins une deuxième plage des amplitudes que l'oscillateur mécanique est susceptible d'avoir de ce second côté, le long de l'axe général d'oscillation, pour la plage de fonctionnement utile de cet oscillateur mécanique.

Dans une variante préférée, chacune des deux parties de la plage de positions du résonateur mécanique identifiées ci-avant, incorporant respectivement les première et deuxième plages des amplitudes que l'oscillateur mécanique est susceptible d'avoir respectivement des deux côtés de la position neutre de son résonateur mécanique, présentent une certaine étendue sur laquelle elle est continue ou quasi continue.

Dans une variante générale, le dispositif de freinage mécanique est agencé de manière que les impulsions de freinage périodiques ont chacune essentiellement une durée inférieure au quart de la période de consigne correspondant à l'inverse de la fréquence de consigne. Dans une variante particulière, les impulsions de freinage périodiques ont essentiellement une durée comprise entre 1/400 et 1/10 de la période de consigne. Dans une variante préférée, les impulsions de freinage périodiques ont une durée comprise entre 1/400 et 1/50 de la période de consigne.

Dans un mode de réalisation préféré, l'oscillateur auxiliaire est incorporé dans le dispositif de régulation que comporte la pièce d'horlogerie.

Grâce aux caractéristiques de l'invention, de manière surprenante, l'oscillateur mécanique du mouvement horloger est synchronisé sur l'oscillateur auxiliaire d'une manière efficace et rapide, comme ceci ressortira par la suite clairement dans la description détaillée de l'invention. Le dispositif de régulation constitue un dispositif de synchronisation de l'oscillateur mécanique (oscillateur mécanique esclave) sur l'oscillateur auxiliaire (oscillateur maître), et ceci sans asservissement à boucle fermée et sans capteur de mesure du mouvement de l'oscillateur mécanique. Le dispositif de régulation fonctionne donc à boucle ouverte et il permet de corriger aussi bien une avance qu'un retard dans la marche naturelle du mouvement mécanique, comme ceci sera exposé par la suite. Ce résultat est tout-à-fait remarquable. Par 'synchronisation sur un oscillateur maître', on comprend ici un asservissement (à boucle ouverte, sans rétroaction) de l'oscillateur mécanique esclave à l'oscillateur maître. Le fonctionnement du dispositif de régulation est tel que la fréquence de freinage, dérivée de la fréquence de référence de l'oscillateur maître, est imposée à l'oscillateur mécanique esclave qui cadence la marche du mécanisme indicateur d'une donnée temporelle. Nous ne sommes pas ici dans la situation d'oscillateurs couplés, ni même dans le cas standard d'un oscillateur forcé. Dans la présente invention, la fréquence de freinage des impulsions de freinage mécanique détermine la fréquence moyenne de l'oscillateur mécanique esclave.

On comprend par 'cadencer la marche d'un mécanisme' le fait de rythmer le mouvement des éléments mobiles de ce mécanisme lorsqu'il fonctionne, en particulier de déterminer les vitesses de rotation de ses roues et ainsi d'au moins un indicateur d'une donnée temporelle. Par 'fréquence de freinage', on comprend une fréquence donnée à laquelle les impulsions de freinage sont périodiquement appliquées au résonateur mécanique esclave.

Dans un mode de réalisation préféré, le système formé du résonateur mécanique et du dispositif de freinage mécanique est configuré de manière à permettre au dispositif de freinage mécanique de débuter, dans la plage de fonctionnement utile de l'oscillateur mécanique esclave, une impulsion de freinage mécanique sensiblement à tout instant de la période d'oscillation naturelle de cet oscillateur mécanique esclave. En d'autres termes, une des impulsions de freinage périodiques peut débuter sensiblement à n'importe quelle position du résonateur mécanique le long de l'axe général d'oscillation.

De manière générale, les impulsions de freinage ont un caractère dissipatif car une partie de l'énergie de l'oscillateur est dissipée par ces impulsions de freinage. Dans un mode de réalisation principal, le couple de freinage mécanique est appliqué substantiellement par frottement, en particulier au moyen d'un organe de freinage mécanique exerçant une certaine pression sur une surface de freinage du résonateur mécanique qui présente une certaine étendue (non ponctuelle) le long de l'axe d'oscillation.

Dans un mode de réalisation particulier, les impulsions de freinage exercent un couple de freinage mécanique sur le résonateur mécanique dont la valeur est prévue pour ne pas bloquer momentanément ce résonateur mécanique au cours des impulsions de freinage périodiques. Dans ce cas, de préférence, le système susmentionné est agencé pour permettre que le couple de freinage mécanique engendré par chacune des impulsions de freinage soit appliqué au résonateur mécanique durant un certain intervalle de temps continu ou quasi continu (non nul ou ponctuel, mais ayant une certaine durée significative).

L'invention concerne aussi un module de synchronisation d'un oscillateur mécanique que comprend une pièce d'horlogerie et qui cadence la marche d'un mécanisme horloger de cette pièce d'horlogerie, ce module de synchronisation étant défini dans la revendication indépendante 18 annexée.

Dans un mode de réalisation particulier du module de synchronisation, le dispositif de freinage mécanique comprend un organe de freinage qui est agencé pour être actionné à la fréquence de freinage de manière à pouvoir venir momentanément en contact avec un organe oscillant du résonateur mécanique pour exercer ledit couple de freinage mécanique sur cet organe oscillant durant lesdites impulsions de freinage périodiques.

Dans une variante avantageuse, l'organe de freinage est agencé de manière que les impulsions de freinage périodiques puissent être appliquées à l'organe oscillant, au moins dans une majeure partie d'une phase transitoire éventuelle pouvant intervenir notamment après une activation du module de synchronisation, principalement par un frottement sec dynamique entre l'organe de freinage et une surface de freinage de l'organe oscillant.

### Brève description des figures

L'invention sera décrite ci-après en détails à l'aide des dessins annexés, donnés à titre d'exemples nullement limitatifs, dans lesquels :
- La Figure 1 montre schématiquement un mode de réalisation général d'une pièce d'horlogerie selon l'invention,
- La Figure 2 montre un premier mode de réalisation particulier d'une pièce d'horlogerie selon l'invention,
- La Figure 3 montre le schéma électronique du circuit de commande de l'actuateur du dispositif de correction incorporé dans le premier mode de réalisation particulier,
- La Figure 4 montre un deuxième mode de réalisation particulier d'une pièce d'horlogerie selon l'invention,
- La Figure 5 montre un troisième mode de réalisation particulier d'une pièce d'horlogerie selon l'invention,
- La Figure 6 montre l'application d'une première impulsion de freinage à un résonateur mécanique dans une certaine alternance de son oscillation avant qu'il passe par sa position neutre, ainsi que la vitesse angulaire du balancier de ce résonateur mécanique et sa position angulaire dans un intervalle temporel au cours duquel intervient la première impulsion de freinage,
- La Figure 7 est une figure similaire à la Figure 6 mais pour l'application d'une deuxième impulsion de freinage dans une certaine alternance de l'oscillation d'un oscillateur mécanique après qu'il a passé par sa position neutre,
- Les Figures 8A, 8B et 8C montrent respectivement la position angulaire d'un balancier-spiral au cours d'une période d'oscillation, la variation de la marche du mouvement horloger obtenue pour une impulsion de freinage de durée fixe, pour trois valeurs d'un couple de freinage constant, en fonction de la position angulaire du balancier spiral, et la puissance de freinage correspondante,
- Les Figures 9, 10 et 11 montrent respectivement trois situations différentes pouvant intervenir dans une phase initiale suite à l'enclenchement du dispositif de correction dans une pièce d'horlogerie selon l'invention,
- La Figure 12 est un graphe explicatif du processus physique intervenant suite à l'enclenchement du dispositif de correction dans la pièce d'horlogerie selon l'invention et conduisant à la synchronisation voulue pour le cas où la fréquence naturelle de l'oscillateur mécanique esclave est supérieure à la fréquence de consigne,
- La Figure 13 représente, dans le cas de la Figure 12, une oscillation de l'oscillateur mécanique esclave et les impulsions de freinage dans une phase synchrone stable pour une variante où une impulsion de freinage intervient dans chaque alternance,
- La Figure 14 est un graphe explicatif du processus physique intervenant suite à l'enclenchement du dispositif de correction dans la pièce d'horlogerie selon l'invention et conduisant à la synchronisation voulue pour le cas où la fréquence naturelle de l'oscillateur mécanique esclave est inférieure à la fréquence de consigne,
- La Figure 15 représente, dans le cas de la Figure 14, une oscillation de l'oscillateur mécanique esclave et les impulsions de freinage dans une phase synchrone stable pour une variante où une impulsion de freinage intervient dans chaque alternance,
- Les Figures 16 et 17 donnent, respectivement pour les deux cas des Figures 12 et 14, le graphe de la position angulaire d'un oscillateur mécanique et les périodes d'oscillation correspondantes pour un mode de fonctionnement du dispositif de correction où une impulsion de freinage intervient toutes les quatre périodes d'oscillation,
- Les Figures 18 et 19 sont respectivement des agrandissements partiels des Figures 16 et 17,
- La figure 20 représente, de manière similaire aux deux figures précédentes, une situation spécifique dans laquelle la fréquence d'un oscillateur mécanique est égale à la fréquence de freinage,
- La Figure 21 montre, pour une variante d'une pièce d'horlogerie selon l'invention, l'évolution de la période d'oscillation de l'oscillateur mécanique esclave ainsi que l'évolution de l'erreur temporelle totale,
- La Figure 22 montre, pour une autre variante d'une pièce d'horlogerie selon l'invention, le graphe de l'oscillation de l'oscillateur mécanique esclave dans une phase initiale suivant l'enclenchement du dispositif de correction d'une dérive temporelle éventuelle.

### Description détaillée de l'invention

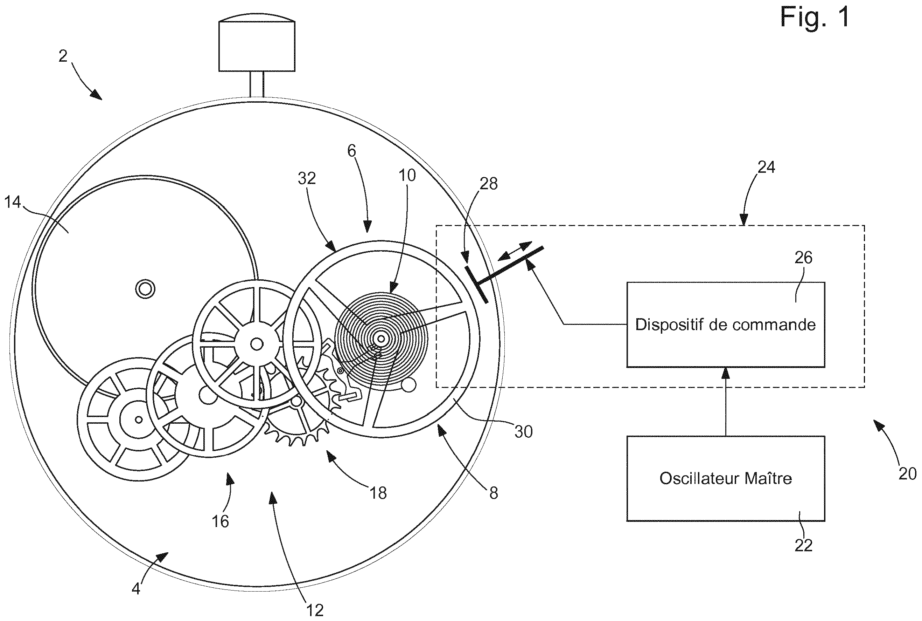

A la Figure 1 est représentée, en partie schématiquement, un mode de réalisation général d'une pièce d'horlogerie 2 selon la présente invention. Elle comprend un mouvement horloger mécanique 4 qui comporte au moins un mécanisme 12 indicateur d'une donnée temporelle, ce mécanisme comprenant un rouage 16 entraîné par un barillet 14 (le mécanisme est représenté partiellement à la Figure 1). Le mouvement mécanique comprend encore un résonateur mécanique 6, formé par un balancier 8 et un spiral 10, et un dispositif d'entretien de ce résonateur mécanique qui est formé par un échappement 18, ce dispositif d'entretien formant avec le résonateur mécanique un oscillateur mécanique qui cadence la marche du mécanisme indicateur. L'échappement 18 comprend classiquement une ancre et une roue d'échappement, cette dernière étant reliée cinématiquement au barillet par l'intermédiaire du rouage 16. Le résonateur mécanique est susceptible d'osciller, autour d'une position neutre (position de repos / position angulaire zéro) correspondant à son état d'énergie potentielle minimale, le long d'un axe circulaire dont le rayon correspond par exemple au rayon extérieur de la serge du balancier. Comme la position du balancier est donnée par sa position angulaire, on comprend que le rayon de l'axe circulaire est ici sans importance. Il définit un axe général d'oscillation qui indique la nature du mouvement du résonateur mécanique, lequel peut être par exemple linéaire dans un mode de réalisation spécifique. Chaque oscillation du résonateur mécanique définit une période d'oscillation.

La pièce d'horlogerie 2 comprend en outre un dispositif de correction d'une dérive temporelle éventuelle dans le fonctionnement de l'oscillateur mécanique du mouvement mécanique 4, ce dispositif de correction 20 comprenant à cet effet un dispositif de freinage mécanique 24 et un oscillateur auxiliaire 22, nommé par la suite également oscillateur maître, qui est associé au dispositif de commande 26 du dispositif de freinage mécanique pour lui fournir une fréquence de référence. L'oscillateur maître 22 est un oscillateur auxiliaire dans la mesure où l'oscillateur principal, qui cadence directement la marche du mouvement horloger, est l'oscillateur mécanique susmentionné, ce dernier étant ainsi un oscillateur esclave. On notera que divers types d'oscillateurs auxiliaires peuvent être prévus, notamment du type électronique, comme un oscillateur avec un résonateur à quartz, ou même un oscillateur intégré entièrement dans un circuit électronique avec le circuit de commande. Généralement, l'oscillateur auxiliaire est par nature ou par construction plus précis que l'oscillateur mécanique principal tel qu'agencé dans le mouvement horloger.

De manière générale, le dispositif de freinage mécanique 24 est agencé pour pouvoir appliquer périodiquement au résonateur mécanique 6 des impulsions de freinage mécanique à une fréquence de freinage sélectionnée en fonction d'une fréquence / période de consigne et déterminée par l'oscillateur maître 22. Cette fonction est représentée schématiquement à la Figure 1 par un organe de freinage 28 comprenant un patin susceptible de venir en contact avec la surface latérale externe 32 de la serge 30 du balancier. Cet organe de freinage est mobile (ici en translation), de manière à pouvoir exercer momentanément un couple de freinage sur le résonateur mécanique 6, et son mouvement de va-et-vient est commandé par le dispositif de commande 26 qui l'actionne périodiquement à la fréquence de freinage de manière que l'organe de freinage vienne périodiquement en contact avec le balancier pour lui appliquer des impulsions de freinage mécanique.

Ensuite, le système, formé du résonateur mécanique 6 et du dispositif de freinage mécanique 24, est configuré de manière à permettre au dispositif de freinage mécanique de pouvoir débuter les impulsions de freinage mécanique à n'importe quelle position du résonateur mécanique au moins dans une certaine plage continue ou quasi continue de positions par lesquelles ce résonateur mécanique est susceptible de passer le long de son axe général d'oscillation. Le cas représenté à la Figure 1 correspond à une variante préférée dans laquelle le système formé du résonateur mécanique et du dispositif de freinage mécanique est configuré de manière à permettre au dispositif de freinage mécanique d'appliquer une impulsion de freinage mécanique au résonateur mécanique sensiblement à tout instant d'une période d'oscillation dans la plage de fonctionnement utile de l'oscillateur mécanique esclave. En effet, la surface latérale externe 32 de la serge 30 est ici continue et circulaire, de sorte que le patin de l'organe de freinage 28, qui se déplace radialement, peut exercer un couple de freinage à toute position angulaire du balancier. Ainsi, en particulier, une impulsion de freinage peut débuter à n'importe quelle position angulaire du résonateur mécanique entre les deux positions angulaires extrêmes (les deux amplitudes de l'oscillateur mécanique esclave respectivement des deux côtés du point neutre de son résonateur mécanique) qu'il est susceptible d'atteindre lorsque l'oscillateur mécanique esclave est fonctionnel.

Finalement, les impulsions de freinage mécanique périodiques ont chacune essentiellement une durée inférieure au quart de la période de consigne prévue pour l'oscillation de l'oscillateur mécanique esclave formé par le résonateur mécanique 6 et le dispositif d'entretien 12.

Dans un mode de réalisation avantageux, les divers éléments du dispositif de correction 20 forment un module indépendant du mouvement mécanique 4. Ainsi, ce module de synchronisation peut être assemblé ou associé au mouvement mécanique que lors de leur montage dans une boîte de montre dans une étape d'assemblage terminale intervenant avant l'emboîtage. En particulier, un tel module peut-être fixé à un cercle d'emboîtage qui entoure le mouvement horloger. On comprend que le module de synchronisation peut donc être avantageusement associé au mouvement horloger une fois ce dernier entièrement monté et réglé, le montage et démontage de ce module pouvant intervenir sans devoir intervenir sur le mouvement mécanique lui-même.

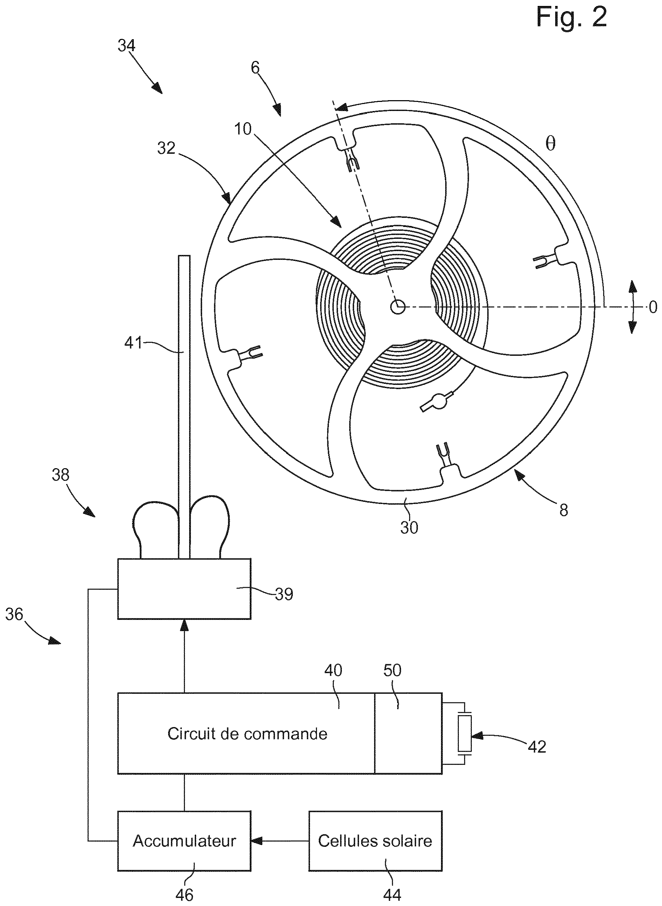

Avant de décrire en détails le fonctionnement remarquable d'une telle pièce d'horlogerie et comment la synchronisation de l'oscillateur mécanique principal sur l'oscillateur auxiliaire maître est obtenue, on décrira à l'aide des Figures 2 à 5 quelques modes de réalisation particuliers avec un oscillateur auxiliaire du type électrique / électronique et un dispositif de freinage mécanique du type électromécanique.

Selon un premier mode de réalisation particulier représenté à la Figure 2, la pièce d'horlogerie 34 comprend un mouvement horloger mécanique (seul le résonateur 6 étant représenté) et un dispositif 36 de correction d'une dérive temporelle éventuelle pour un mécanisme d'affichage d'au moins une donnée temporelle dont la marche est cadencée par l'oscillateur mécanique formé par le résonateur 6. Le dispositif de correction 36 comprend un actionneur électromécanique 38, un circuit électronique formé du circuit électronique de commande 40 et du circuit d'horloge 50, un résonateur à quartz 42, une cellule solaire 44 et un accumulateur 46 stockant l'énergie électrique fournie par la cellule solaire. L'actionneur 38 est formé par un circuit d'alimentation 39 et un organe de freinage mobile 41, lequel est actionné en réponse à un signal de commande fourni par le circuit électronique de commande 40 de manière à exercer sur l'organe oscillant du résonateur mécanique 6 une certaine force mécanique durant les impulsions de freinage mécanique prévues. A cet effet, l'actionneur 38 comprend un élément piézoélectrique qui est alimenté par le circuit 39, une tension électrique étant appliquée à cet élément piézoélectrique en fonction du signal de commande. Lorsque l'élément piézoélectrique est mis momentanément sous tension, l'organe de freinage vient en contact avec une surface de freinage du balancier pour le freiner.

Dans l'exemple représenté à la Figure 2, la lame 41 formant l'organe de freinage se courbe lorsque la tension électrique est appliquée et sa partie d'extrémité vient presser contre la surface latérale circulaire 32 de la serge 30 du balancier 8. Ainsi, cette serge définit une surface de freinage circulaire. L'organe de freinage comprend une partie mobile, ici la partie d'extrémité de la lame 41, qui définit un patin de freinage agencé de manière à venir exercer une pression contre la surface de freinage circulaire lors de l'application des impulsions de freinage mécanique. Une surface de freinage circulaire, pour un organe oscillant qui est pivoté (balancier) et au moins un patin de freinage mobile radialement constitue dans le cadre de l'invention un système de freinage mécanique qui présente des avantages déterminants. En effet, dans une variante préférée, il est prévu que l'organe oscillant et l'organe de freinage sont agencés de manière que les impulsions de freinage mécanique sont appliquées par un frottement sec dynamique entre l'organe de freinage et la surface de freinage de l'organe oscillant.

On remarquera que la surface de freinage peut être autre que la surface latérale externe de la serge du balancier. Dans une variante non représentée, c'est l'arbre central du balancier qui définit une surface de freinage circulaire. Dans ce cas, un patin de l'organe de freinage est agencé de manière à venir exercer une pression contre cette surface de l'arbre central lors de l'application des impulsions de freinage mécanique.

A titre d'exemples non limitatifs, pour un résonateur horloger formé par un balancier-spiral, dont la constante du spiral k = 5.75 E-7 Nm/rad et l'inertie I = 9.1 E-10 kg·m², et une fréquence de consigne FOc égale à 4 Hz, on peut considérer une première variante pour un mouvement horloger dont la marche non synchronisée est peu précise, avec une erreur journalière d'environ cinq minutes, et une deuxième variante pour un autre mouvement horloger dont la marche non synchronisée est plus précise avec une erreur journalière d'environ trente secondes. Dans la première variante, la plage de valeurs pour le couple de freinage est comprise entre 0.2 µNm et 10 µNm, la plage de valeurs pour la durée des impulsions de freinage est comprise entre 5 ms et 20 ms et la plage de valeurs relative à la période de freinage pour l'application des impulsions de freinage périodiques est comprise entre 0.5 s et 3 s. Dans la deuxième variante, la plage de valeurs pour le couple de freinage est comprise entre 0.1 µNm et 5 µNm, la plage de valeurs pour la durée des impulsions de freinage périodiques est comprise entre 1 ms et 10 ms et la plage de valeurs pour la période de freinage est comprise entre 3 s et 60 s, soit au minimum une fois par minute.

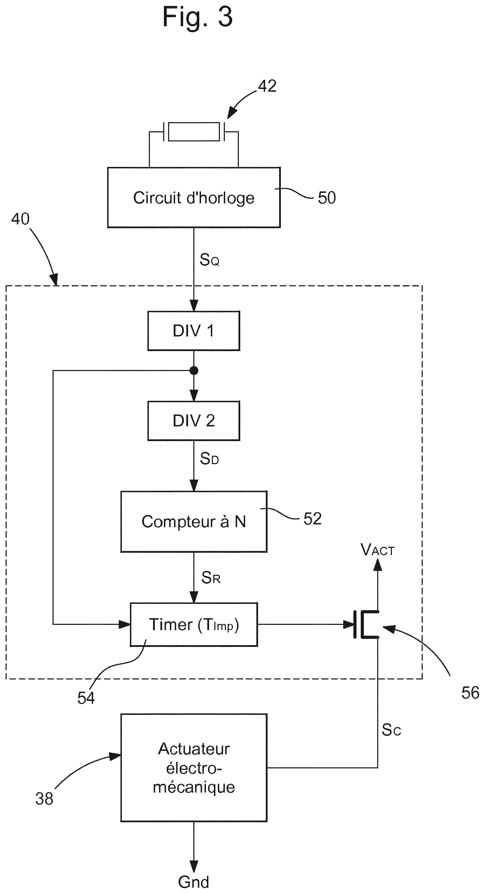

La Figure 3 est un schéma qui montre une variante de réalisation du circuit de commande 40 de la pièce d'horlogerie 34. Ce circuit de commande est relié d'une part au circuit d'horloge 50 et, d'autre part, à l'actuateur électromécanique 38. Le circuit d'horloge 50 entretient le résonateur à quartz 42 et génère en retour un signal d'horloge S_{Q} à une fréquence de référence, notamment égale à 2¹⁵ Hz. Le résonateur à quartz et le circuit d'horloge forment ensemble un oscillateur maître. Le signal d'horloge S_{Q} est fourni successivement à deux diviseurs DIV1 et DIV2 (ces deux diviseurs pouvant former deux étages d'un même diviseur). Le Diviseur DIV2 fournit un signal périodique S_{D} à un compteur 52. La fréquence du signal S_{D} est par exemples égale à 1Hz, 2Hz ou 4Hz. Le compteur 52 est un compteur à N, c'est-à-dire qu'il compte en boucle un nombre N d'impulsions successives du signal S_{D} et délivre une impulsion chaque fois qu'il atteint ce nombre N via le signal S_{R} qu'il fournit à un minuteur 54 ('Timer'). A chaque impulsion reçue, le minuteur ouvre immédiatement l'interrupteur 56 pour mettre sous tension et donc alimenter l'actuateur électromécanique 38 pour une durée Timp définissant la durée de chaque impulsion de freinage. Comme cette durée est prévue essentiellement inférieure à T0_{C}/4 (T0_{C} étant la période de consigne de l'oscillateur mécanique) et de préférence bien inférieure à cette valeur, notamment entre 1 ms et 10 ms, le minuteur reçoit un signal de cadencement du diviseur DIV1.

Dans un exemple où la fréquence de consigne FOc de l'oscillateur mécanique est égal à 4 Hz (F0_{C} = 4 Hz), la fréquence des impulsions du signal S_{D} égale à 8 Hz et le nombre N égal à 16, la fréquence de freinage F_{FR} du signal S_{R} est alors de 0.5 Hz, ce qui veut dire qu'il est prévu une impulsion de freinage par huit périodes T0_{C}, soit environ chaque huit périodes de l'oscillateur mécanique dans la mesure où sa fréquence naturelle F0 est proche de la fréquence de consigne F0_{C}. Dans une variante, le compteur 52 est omis et c'est le diviseur DIV2 qui délivre directement des impulsions au minuteur pour l'enclencher périodiquement. Dans ce cas-là, de préférence, la fréquence des impulsions du signal S_{D} est égale ou inférieure au double de la fréquence de consigne F0. Ainsi, pour F0 = 4 Hz, la fréquence du signal S_{D} est égale ou inférieure à 8 Hz, car il est prévu de préférence au maximum une impulsion de freinage par alternance de l'oscillateur mécanique.

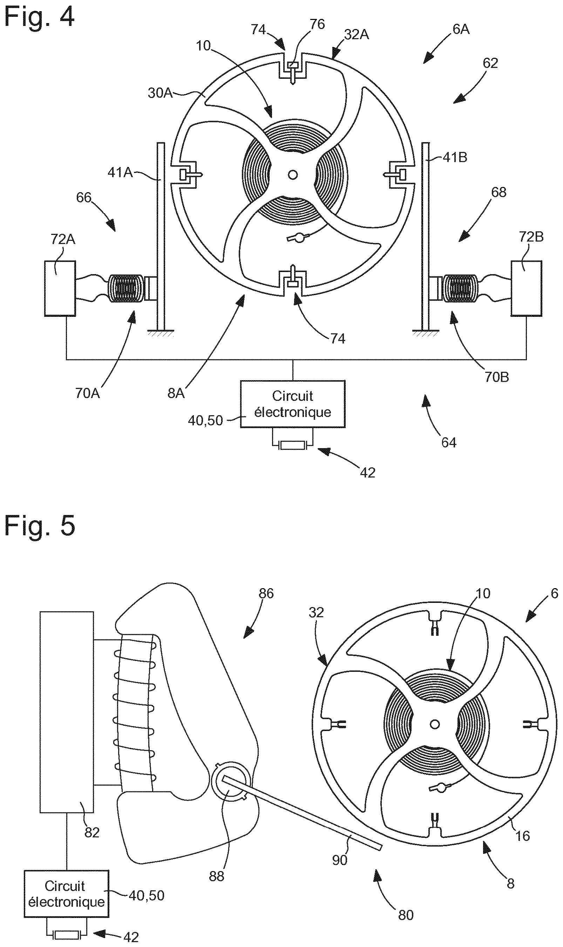

En référence à la Figure 4, on décrira ci-après un deuxième mode de réalisation particulier d'une pièce d'horlogerie 62, laquelle se distingue la précédente premièrement par l'agencement de son dispositif de freinage 64. L'actionneur de ce dispositif de freinage comprend deux modules de freinage 66 et 68 formés chacun par une lame 41A, respectivement 41B actionnée par un système magnétique aimant-bobine 70A, respectivement 70B. Les bobines des deux systèmes magnétiques sont respectivement commandées par deux circuits d'alimentation 72A et 72B qui sont reliés électriquement au circuit électronique 40, 50. Les lames 41A et 41B forment respectivement un premier organe de freinage et un deuxième organe de freinage qui définissent deux patins pouvant venir s'appuyer contre la surface latérale externe 32A de la serge 30A du balancier 8A. Ces deux patins de freinage sont agencés de manière que, lors de l'application des impulsions de freinage périodiques, ils viennent exercer sur la serge du balancier respectivement deux forces radiales diamétralement opposées relativement à l'axe de rotation du balancier et de sens opposés. Bien entendu, le couple de force exercé par chacun des deux patins lors d'une impulsion de freinage est prévu sensiblement égale à l'autre. Ainsi, la résultante des forces dans le plan général du balancier est sensiblement nulle de sorte qu'aucune force radiale ne s'exerce sur l'arbre du balancier lors des impulsions de freinage. Ceci évite des contraintes mécaniques sur les pivots du balancier et plus généralement au niveau des paliers associés à ces pivots. Un tel agencement peut avantageusement être incorporé dans une variante où le freinage est effectué sur l'arbre du balancier ou sur un disque porté par cet arbre.

Ensuite, le résonateur 6A se distingue de celui du mode précédent par le fait que le balancier 8A comprend une serge 30A présentant des cavités 74 (dans le plan général du balancier) dans lesquelles sont logées des vis 76 d'équilibrage du balancier. Ainsi, la surface latérale externe 32A ne définit plus une surface circulaire continue, mais une surface circulaire discontinue avec quatre secteurs angulaires continus. On remarquera cependant que les lames 41A et 41B présentent des surfaces de contact avec une étendue telle que des impulsions de freinage demeurent possible pour toute position angulaire du balancier, même lorsque que deux cavités se présentent respectivement en regard des extrémités de deux lames, comme représenté à la Figure 4.

Dans une variante de réalisation, la force de freinage exercée sur le balancier est prévue axiale. Dans une telle variante, il est avantageux de prévoir un dispositif de freinage mécanique du type du deuxième mode de réalisation, c'est-à-dire avec deux patins de freinage agencés axialement en vis-à-vis et entre lesquels passe notamment la serge du balancier. Ainsi, l'actionneur est agencé de manière que, lors de l'application des impulsions de freinage périodiques, les deux patins viennent exercer sur le balancier deux forces axiales sensiblement alignées et de sens opposés. Le couple de force exercé par chacun des deux patins lors d'une impulsion de freinage est prévu ici aussi sensiblement égal à l'autre.

Une pièce d'horlogerie 80 selon un troisième mode de réalisation particulier est montrée à la Figure 5. Elle se distingue du premier mode de réalisation essentiellement par le choix de l'actionneur qui comprend un moteur du type horloger 86 et un organe de freinage 90 qui est monté sur un rotor 88 (à aimant permanent) de ce moteur de manière à venir exercer une certaine force sur la serge du balancier 8 du résonateur 6 lorsque le rotor effectue une certaine rotation, laquelle est engendrée par une alimentation 82 d'une bobine du moteur durant les impulsions de freinage en réponse à un signal de commande fourni par le circuit de commande 40.

Selon diverses variantes, l'actionneur électromécanique comprend un élément piézoélectrique ou un élément magnétostrictif ou, pour actionner ledit organe de freinage, un système électromagnétique.

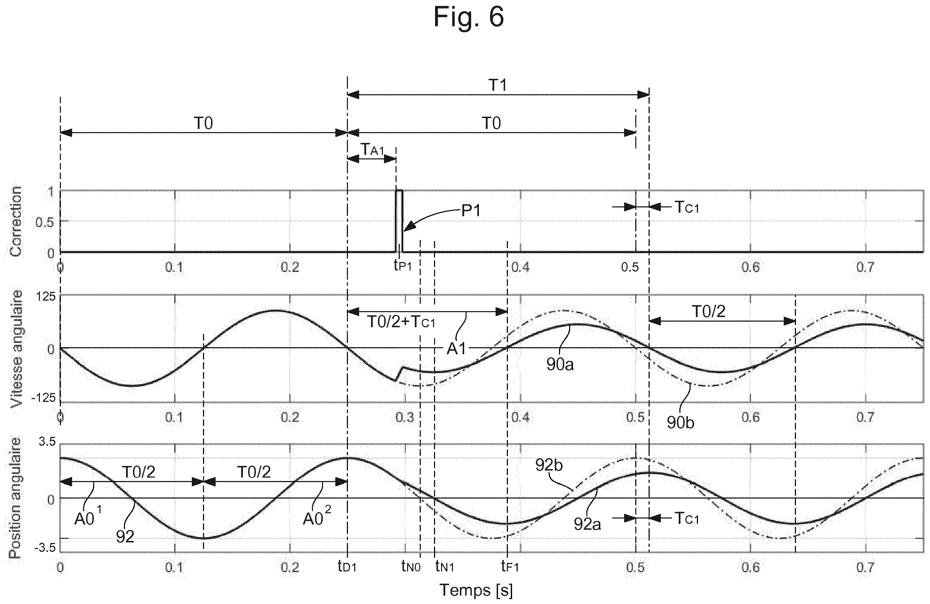

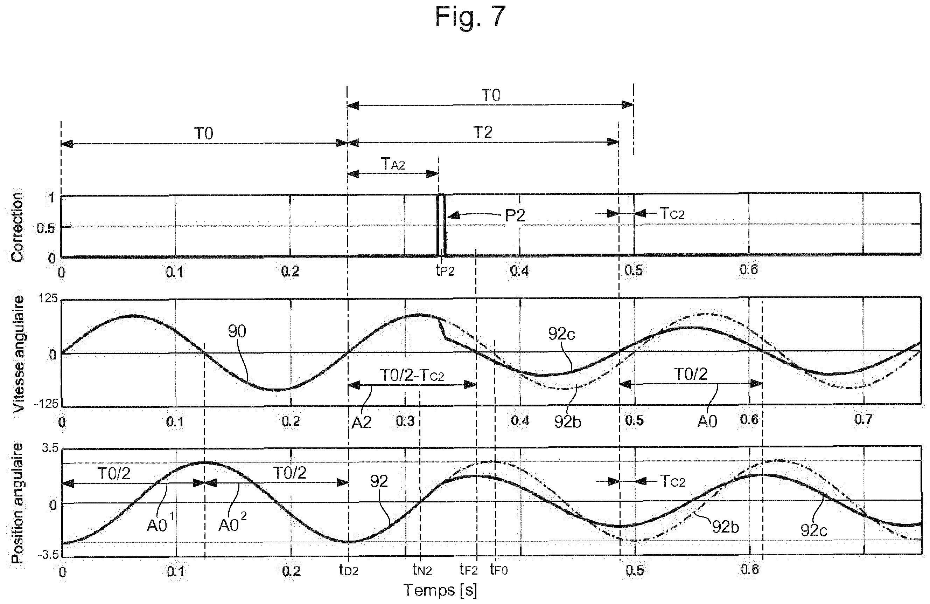

On décrira ci-après, en référence aux Figures 6 et 7, un phénomène physique remarquable mis en lumière dans le cadre de développements ayant conduit à la présente invention et intervenant dans le procédé de synchronisation implémenté dans la pièce d'horlogerie selon l'invention. La compréhension de ce phénomène permettra de mieux comprendre la synchronisation obtenue par le dispositif de correction régulant la marche du mouvement mécanique, résultat qui sera décrit par la suite en détails.

Aux Figures 6 et 7, le premier graphe indique l'instant t_{P1} auquel une impulsion de freinage P1, respectivement P2 est appliquée au résonateur mécanique considéré pour effectuer une correction de la marche du mécanisme qui est cadencée par l'oscillateur mécanique formé par ce résonateur. Les deux derniers graphes montrent respectivement la vitesse angulaire (valeurs en radian par seconde : [rad/s]) et la position angulaire (valeurs en radian : [rad]) de l'organe oscillant (par la suite aussi 'le balancier') du résonateur mécanique au cours du temps. Les courbes 90 et 92 correspondent respectivement à la vitesse angulaire et à la position angulaire du balancier oscillant librement (oscillation à sa fréquence naturelle) avant l'intervention d'une impulsion de freinage. Après l'impulsion de freinage sont représentées les courbes de vitesse 90a et 90b correspondant au comportement du résonateur respectivement dans le cas perturbé par l'impulsion de freinage et le cas non perturbé. De même, les courbes de position 92a et 92b correspondent au comportement du résonateur respectivement dans le cas perturbé par l'impulsion de freinage et le cas non perturbé. Aux figures, les instants t_{P1} et t_{P2} auxquels interviennent les impulsions de freinage P1 et P2 correspondent aux positions temporelles du milieu de ces impulsions. Cependant, on considère le début de l'impulsion de freinage et sa durée comme les deux paramètres qui définissent temporellement une impulsion de freinage.

On remarquera que les impulsions P1 et P2 sont représentées aux figures 6 et 7 par des signaux binaires. Cependant, dans les explications qui suivent, on considère des impulsions de freinage mécanique appliquées au résonateur mécanique et non des impulsions de commande. Ainsi, on notera que, dans certains modes de réalisation, en particulier avec des dispositifs de correction mécanique ayant un dispositif de commande mécanique, l'impulsion de commande peut intervenir au moins en partie avant l'application d'une impulsion de freinage mécanique. Dans un tel cas, dans les explications suivantes, les impulsions de freinage P1, P2 correspondent aux impulsions de freinage mécanique appliquées au résonateur et non à des impulsions de commande antérieures.

On notera encore que les impulsions de freinage peuvent être appliquées avec un couple de force constant ou un couple de force non constant (par exemple sensiblement en courbe de Gauss ou sinusoïdal). Par impulsion de freinage, on comprend l'application momentanée d'un couple de force au résonateur mécanique qui freine son organe oscillant (balancier), c'est-à-dire qui s'oppose au mouvement d'oscillation de cet organe oscillant. Dans le cas d'un couple non nul qui est variable, la durée de l'impulsion est définie généralement comme la partie de cette impulsion qui présente un couple de force significatif pour freiner le résonateur mécanique. On notera qu'une impulsion de freinage peut présenter une forte variation. Elle peut même être hachée et former une succession d'impulsions plus courtes. Dans le cas d'un couple constant, la durée de chaque impulsion est prévue inférieure à une demi-période de consigne et de préférence inférieure à un quart d'une période de consigne. On notera que chaque impulsion de freinage peut soit freiner le résonateur mécanique sans toutefois le stopper, comme aux Figures 6 et 7, soit l'arrêter au cours de l'impulsion de freinage et le stopper momentanément durant le reste de cette impulsion de freinage.

Chaque période d'oscillation libre T0 de l'oscillateur mécanique définit une première alternance A0**¹** suivie d'une deuxième alternance A0**²** intervenant chacune entre deux positions extrêmes définissant l'amplitude d'oscillation de cet oscillateur mécanique, chaque alternance ayant une durée identique T0/2 et présentant un passage du résonateur mécanique par sa position zéro à un instant médian. Les deux alternances successives d'une oscillation définissent deux demi-périodes au cours desquelles le balancier subit respectivement un mouvement d'oscillation dans un sens et ensuite un mouvement d'oscillation dans l'autre sens. En d'autres termes, une alternance correspond ici à un balancement du balancier dans un sens ou l'autre sens entre ses deux positions extrêmes définissant l'amplitude d'oscillation. De manière générale, on observe une variation de la période d'oscillation au cours de laquelle interviennent une impulsion de freinage et donc une variation ponctuelle de la fréquence de l'oscillateur mécanique. De fait, la variation temporelle concerne la seule alternance au cours de laquelle intervient l'impulsion de freinage. Par 'instant médian', on comprend un instant intervenant sensiblement au milieu des alternances. C'est précisément le cas lorsque l'oscillateur mécanique oscille librement. Par contre, pour les alternances où interviennent des impulsions de régulation, cet instant médian ne correspond plus exactement au milieu de la durée de chacune de ces alternances du fait de la perturbation de l'oscillateur mécanique engendrée par le dispositif de régulation.

On décrira premièrement le comportement de l'oscillateur mécanique dans un premier cas de correction de sa fréquence d'oscillation, qui correspond à celui montré à la Figure 6. Après une première période T0 commence alors une nouvelle période T1, respectivement une nouvelle alternance A1 au cours de laquelle intervient une impulsion de freinage P1. A l'instant initial t_{D1} débute l'alternance A1, le résonateur 14 occupant une position angulaire positive maximale correspondant à une position extrême. Ensuite intervient l'impulsion de freinage P1 à l'instant t_{P1} qui est situé avant l'instant médian t_{N1} auquel le résonateur passe par sa position neutre et donc également avant l'instant médian correspondant t_{N0} de l'oscillation non perturbée. Finalement l'alternance A1 se termine à l'instant final t_{F1}. L'impulsion de freinage est déclenchée après un intervalle de temps T_{A1} suivant l'instant t_{D1} marquant le début de l'alternance A1. La durée T_{A1} est inférieure à une demi-alternance T0/4 diminuée de la durée de l'impulsion de freinage P1. Dans l'exemple donné, la durée de cette impulsion de freinage est bien inférieure à une demi-alternance T0/4.

Dans ce premier cas, l'impulsion de freinage est donc générée entre le début d'une alternance et le passage du résonateur par sa position neutre dans cette alternance. La vitesse angulaire en valeur absolue diminue au moment de l'impulsion de freinage P1. Une telle impulsion de freinage induit un déphasage temporel négatif T_{C1} dans l'oscillation du résonateur, comme le montrent à la Figure 6 les deux courbes 90a et 90b de la vitesse angulaire et aussi les deux courbes 92a et 92b de la position angulaire, c'est-à-dire un retard relativement au signal théorique non perturbé (représenté en traits interrompus). Ainsi, la durée de l'alternance A1 est augmentée d'un intervalle de temps T_{C1}. La période d'oscillation T1, comprenant l'alternance A1, est donc prolongée relativement à la valeur T0. Ceci engendre une diminution ponctuelle de la fréquence de l'oscillateur mécanique et un ralentissement momentané du mécanisme associé dont la marche est cadencée par cet oscillateur mécanique.

En référence à la Figure 7, on décrira ci-après le comportement de l'oscillateur mécanique dans un deuxième cas de correction de sa fréquence d'oscillation. Après une première période T0 commence alors une nouvelle période d'oscillation T2, respectivement une alternance A2 au cours de laquelle intervient une impulsion de freinage P2. A l'instant initial t_{D2} débute l'alternance A2, le résonateur mécanique étant alors dans une position extrême (position angulaire négative maximale). Après un quart de période T0/4 correspondant à une demi-alternance, le résonateur atteint sa position neutre à l'instant médian t_{N2}. Ensuite intervient l'impulsion de freinage P2 à l'instant t_{P2} qui est situé dans l'alternance A2 après l'instant médian t_{N2} auquel le résonateur passe par sa position neutre. Finalement, après l'impulsion freinage P2, cette alternance A2 se termine à l'instant final t_{F2} auquel le résonateur occupe à nouveau une position extrême (position angulaire positive maximale dans la période T2) et donc également avant l'instant final correspondant t_{F0} de l'oscillation non perturbée. L'impulsion de freinage est déclenchée après un intervalle de temps T_{A2} suivant l'instant initial t_{D2} de l'alternance A2. La durée T_{A2} est supérieure à une demi-alternance T0/4 et inférieure à une alternance T0/2 diminuée de la durée de l'impulsion de freinage P2. Dans l'exemple donné, la durée de cette impulsion de freinage est bien inférieure à une demi-alternance.

Dans le deuxième cas considéré, l'impulsion de freinage est donc générée, dans une alternance, entre l'instant médian auquel le résonateur passe par sa position neutre (position zéro) et l'instant final auquel se termine cette alternance. La vitesse angulaire en valeur absolue diminue au moment de l'impulsion de freinage P2. De manière remarquable, l'impulsion de freinage induit ici un déphasage temporel positif T_{C2} dans l'oscillation du résonateur, comme le montrent à la Figure 4 les deux courbes 90b et 90c de la vitesse angulaire et aussi les courbes 92b et 92c de la position angulaire, soit une avance relativement au signal théorique non perturbé (représenté en traits interrompus). Ainsi, la durée de l'alternance A2 est diminuée de l'intervalle de temps T_{C2}. La période d'oscillation T2 comprenant l'alternance A2 est donc plus courte que la valeur T0. Ceci engendre par conséquent une augmentation ponctuelle de la fréquence de l'oscillateur mécanique et une accélération momentanée du mécanisme associé dont la marche est cadencée par cet oscillateur mécanique. Ce phénomène est surprenant et non intuitif, raison pour laquelle l'homme du métier l'a ignoré par le passé. En effet, obtenir une accélération du mécanisme par une impulsion de freinage est a priori étonnant, mais tel est bien le cas lorsque cette marche est cadencée par un oscillateur mécanique et que l'impulsion de freinage est appliquée à son résonateur.

Le phénomène physique susmentionné pour des oscillateurs mécaniques intervient dans le procédé de synchronisation implémenté dans une pièce d'horlogerie selon l'invention. Contrairement à l'enseignement général dans le domaine horloger, il est possible non seulement de diminuer la fréquence d'un oscillateur mécanique par des impulsions de freinage, mais il est aussi possible d'augmenter la fréquence d'un tel oscillateur mécanique également par des impulsions de freinage. L'homme du métier s'attend à pouvoir pratiquement seulement réduire la fréquence d'un oscillateur mécanique par des impulsions de freinage et, comme corolaire, à pouvoir seulement augmenter la fréquence d'un tel oscillateur mécanique par l'application d'impulsions motrices lors d'un apport d'énergie à cet oscillateur. Une telle intuition, qui s'est imposée dans le domaine horloger et vient donc de prime à bord à l'esprit d'un homme du métier, s'avère fausse pour un oscillateur mécanique. Ainsi, comme cela sera exposé par la suite en détail, il est possible de synchroniser, via un oscillateur auxiliaire définissant un oscillateur maître, un oscillateur mécanique par ailleurs très précis, qu'il présente momentanément une fréquence légèrement trop haute ou trop basse. On peut donc corriger une fréquence trop haute ou une fréquence trop basse seulement au moyen d'impulsions de freinage. En résumé, l'application d'un couple de freinage pendant une alternance de l'oscillation d'un balancier-spiral provoque un déphasage négatif ou positif dans l'oscillation de ce balancier-spiral selon que ce couple de freinage est appliqué respectivement avant ou après le passage du balancier-spiral par sa position neutre.

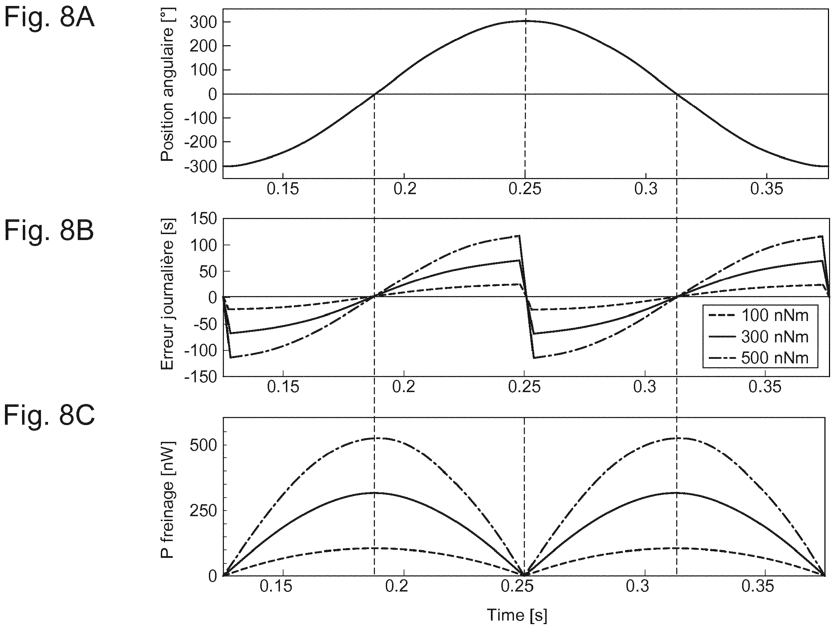

Le procédé de synchronisation résultant du dispositif de correction incorporé dans une pièce d'horlogerie selon l'invention est décrit ci-après. A la Figure 8A est montrée la position angulaire (en degrés) d'un résonateur mécanique horloger oscillant avec une amplitude de 300° au cours d'une période d'oscillation de 250 ms. A la Figure 8B est montrée l'erreur journalière engendrée par des impulsions de freinage d'une milliseconde (1 ms) appliquées dans des périodes d'oscillation successives du résonateur mécanique en fonction de l'instant de leur application à l'intérieur de ces périodes et donc en fonction de la position angulaire du résonateur mécanique. Ici, on part du fait que l'oscillateur mécanique fonctionne librement à une fréquence propre de 4 Hz (cas non perturbé). Trois courbes sont données respectivement pour trois couples de force (100 nNm, 300 nNm et 500 nNm) appliqués par chaque impulsion de freinage. Le résultat confirme le phénomène physique exposé précédemment, à savoir qu'une impulsion de freinage intervenant dans le premier quart de période ou le troisième quart de période engendre un retard provenant d'une diminution de la fréquence de l'oscillateur mécanique, alors qu'une impulsion de freinage intervenant dans le deuxième quart de période ou le quatrième quart de période engendre une avance provenant d'une augmentation de la fréquence de l'oscillateur mécanique. Ensuite, on observe que, pour un couple de force donné, l'erreur journalière est égale à zéro pour une impulsion de freinage intervenant à la position neutre du résonateur, cette erreur journalière augmentant (en valeur absolue) à mesure qu'on s'approche d'une position extrême de l'oscillation. A cette position extrême où la vitesse du résonateur passe par zéro et où le sens du mouvement change, il y a une brusque inversion du signe de l'erreur journalière. Finalement, à la Figure 8C est donnée la puissance de freinage consommée pour les trois valeurs de couple de force susmentionnées en fonction de l'instant d'application de l'impulsion de freinage au cours d'une période d'oscillation. Comme la vitesse diminue en s'approchant des positions extrêmes du résonateur, la puissance de freinage diminue. Ainsi, alors que l'erreur journalière engendrée augmente en s'approchant des positions extrêmes, la puissance de freinage nécessaire (et donc l'énergie perdue par l'oscillateur) diminue de manière importante.

L'erreur engendrée à la Figure 8B peut correspondre de fait à une correction pour le cas où l'oscillateur mécanique présente une fréquence propre qui ne correspond pas à une fréquence de consigne. Ainsi, si l'oscillateur présente une fréquence propre trop basse, des impulsions de freinage intervenant dans le deuxième ou quatrième quart de la période d'oscillation peuvent permettre une correction du retard pris par l'oscillation libre (non perturbée), cette correction étant plus ou moins forte en fonction de l'instant des impulsions de freinage au sein de la période d'oscillation. Par contre, si l'oscillateur présente une fréquence propre trop haute, des impulsions de freinage intervenant dans le premier ou troisième quart de la période d'oscillation peuvent permettre une correction de l'avance prise par l'oscillation libre, cette correction étant plus ou moins forte en fonction de l'instant des impulsions de freinage dans la période d'oscillation.

L'enseignement donné précédemment permet de comprendre le phénomène remarquable de la synchronisation d'un oscillateur mécanique principal (oscillateur esclave) sur un oscillateur auxiliaire, formant un oscillateur maître, par la seule application périodique d'impulsions de freinage sur le résonateur mécanique esclave à une fréquence de freinage F_{FR} correspondant avantageusement au double de la fréquence de consigne FOc divisée par un nombre entier positif N, soit F_{FR} = 2·F0_{C} / N. La fréquence de freinage est ainsi proportionnelle à la fréquence de consigne pour l'oscillateur maître et dépend seulement de cette fréquence de consigne dès que le nombre entier positif N est donné. Comme la fréquence de consigne est prévue égale à un nombre fractionnaire multiplié par la fréquence de référence, la fréquence de freinage est donc proportionnelle à la fréquence de référence et déterminée par cette fréquence de référence, laquelle est fournie par l'oscillateur auxiliaire qui est par nature ou par construction plus précis que l'oscillateur mécanique principal.

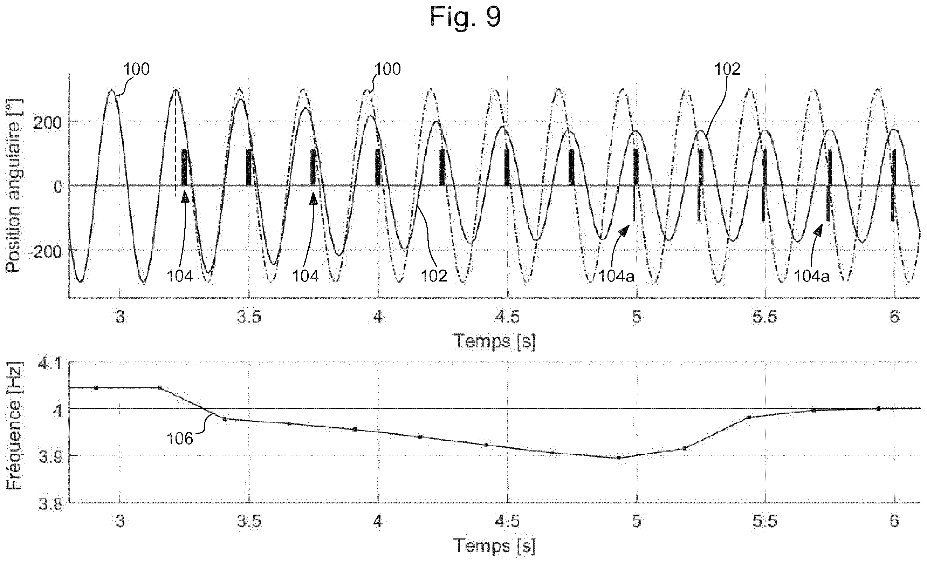

La synchronisation susmentionnée obtenue par le dispositif de correction incorporé dans la pièce d'horlogerie de l'invention sera maintenant décrite plus en détails à l'aide des Figures 9 à 22.

A la Figure 9 est représentée sur le graphe du haut la position angulaire du résonateur mécanique esclave, notamment du balancier-spiral d'un résonateur horloger, oscillant librement (courbe 100) et oscillant avec freinage (courbe 102). La fréquence de l'oscillation libre est supérieure à la fréquence de consigne FOc = 4 Hz. Les premières impulsions de freinage mécanique 104 (ci-après aussi nommées 'impulsions') interviennent ici une fois par période d'oscillation dans une demi-alternance entre le passage par une position extrême et le passage par zéro. Ce choix est arbitraire car le système prévu ne détecte pas la position angulaire du résonateur mécanique ; c'est donc juste une hypothèse possible parmi d'autres qui seront analysées par la suite. On est donc ici dans le cas d'un ralentissement de l'oscillateur mécanique. Le couple de freinage pour la première impulsion de freinage est prévu ici supérieur à un couple de freinage minimum pour compenser l'avance que prend l'oscillateur libre sur une période d'oscillation. Ceci a pour conséquence que la seconde impulsion de freinage a lieu un peu avant la première à l'intérieur du quart de période où interviennent ces impulsions. La courbe 106, qui donne la fréquence instantanée de l'oscillateur mécanique, indique en effet que la fréquence instantanée diminue en-dessous de la fréquence de consigne dès la première impulsion. Ainsi, la seconde impulsion de freinage est plus proche de la position extrême qui précède, de sorte que l'effet du freinage augmente et ainsi de suite avec les impulsions suivantes. Dans une phase transitoire, la fréquence instantanée de l'oscillateur diminue donc progressivement et les impulsions se rapprochent progressivement d'une position extrême de l'oscillation. Après un certain temps, les impulsions de freinage comprennent le passage par la position extrême où la vitesse du résonateur mécanique change de sens et la fréquence instantanée commence alors à augmenter.

Le freinage a ceci de particulier qu'il s'oppose au mouvement du résonateur quel que soit le sens de son mouvement. Ainsi, lorsque le résonateur passe par une inversion du sens de son oscillation au cours d'une impulsion de freinage, le couple de freinage change automatiquement de signe à l'instant de cette inversion. On a alors des impulsions de freinage 104a qui présentent, pour le couple de freinage, une première partie avec un premier signe et une seconde partie avec un deuxième signe opposé au premier signe. Dans cette situation, on a donc la première partie du signal qui intervient avant la position extrême et qui s'oppose à l'effet de la seconde partie qui intervient après cette position extrême. Si la seconde partie diminue la fréquence instantanée de l'oscillateur mécanique, la première partie l'augmente. La correction diminue alors pour se stabiliser finalement et relativement rapidement à une valeur pour laquelle la fréquence instantanée de l'oscillateur est égale à la fréquence de consigne (correspondant ici à la fréquence de freinage). Ainsi, à la phase transitoire succède une phase stable, aussi nommée phase synchrone, où la fréquence d'oscillation est sensiblement égale à la fréquence de consigne et où les première et deuxième parties des impulsions de freinage présente un rapport sensiblement constant et défini.

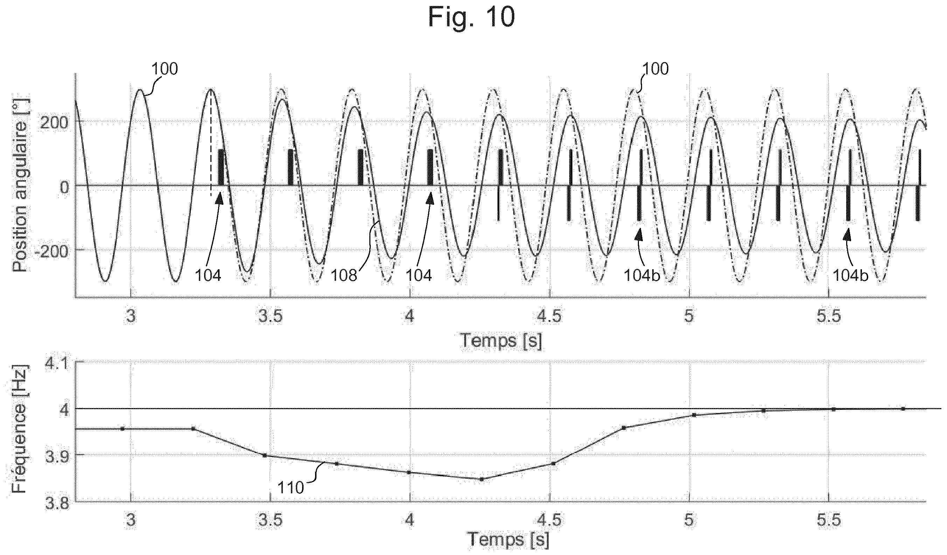

Les graphes de la Figure 10 sont analogues à ceux de la Figure 9. La différence majeure est la valeur de la fréquence naturelle de l'oscillateur mécanique libre qui est inférieure à la fréquence de consigne FOc = 4 Hz. Les premières impulsions 104 interviennent dans la même demi-alternance qu'à la Figure 9. On observe comme attendu une diminution de la fréquence instantanée donnée par la courbe 110. L'oscillation avec freinage 108 prend donc momentanément encore plus de retard dans la phase transitoire, ceci jusqu'à ce que les impulsions 104b commence à englober le passage du résonateur par une position extrême. A partir de ce moment, la fréquence instantanée commence à augmenter jusqu'à atteindre la fréquence de consigne, car la première partie des impulsions intervenant avant la position extrême augmente la fréquence instantanée. Ce phénomène est automatique. En effet, tant que la durée des périodes d'oscillation est supérieure à la durée de la période de consigne T0_{C}, la première partie de l'impulsion augmente alors que la seconde partie diminue et par conséquent la fréquence instantanée continue à augmenter jusqu'à une situation stable où la période de consigne est sensiblement égale à la période d'oscillation. On a donc la synchronisation voulue.

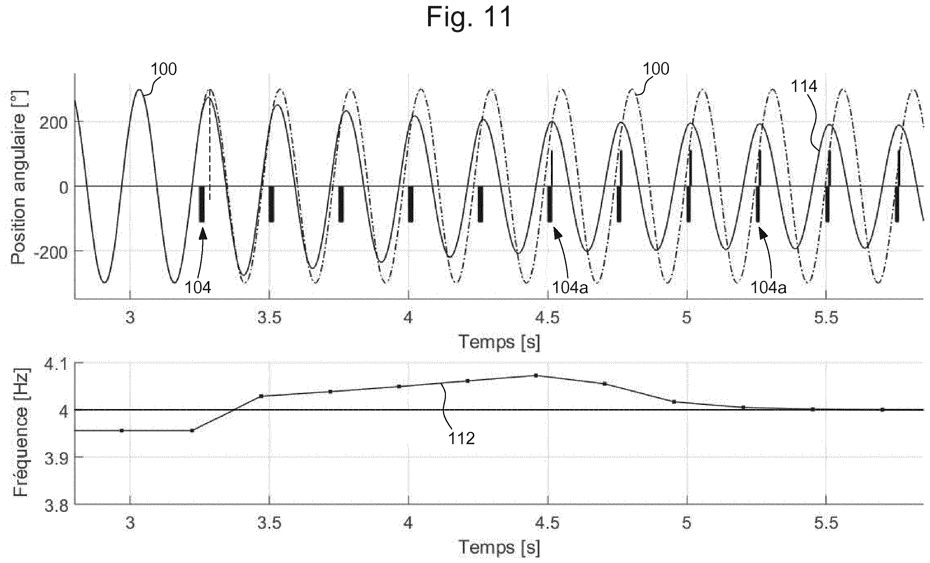

Les graphes de la Figure 11 sont analogues à ceux de la Figure 10. La différence majeure vient du fait que les premières impulsions de freinage 114 interviennent dans une autre demi-alternance qu'à la Figure 10, à savoir dans une demi-alternance entre le passage par zéro et le passage par une position extrême. Selon ce qui a été exposé précédemment, on observe ici dans une phase transitoire une augmentation de la fréquence instantanée donnée par la courbe 112. Le couple de freinage pour la première impulsion de freinage est prévu ici supérieur à un couple de freinage minimum pour compenser le retard que prend l'oscillateur mécanique libre sur une période d'oscillation. Ceci a pour conséquence que la seconde impulsion de freinage a lieu un peu après la première à l'intérieur du quart de période où interviennent ces impulsions. La courbe 112 indique en effet que la fréquence instantanée de l'oscillateur augmente au-dessus de la fréquence de consigne dès la première impulsion. Ainsi, la seconde impulsion de freinage est plus proche de la position extrême qui suit, de sorte que l'effet du freinage augmente et ainsi de suite avec les impulsions suivantes. Dans la phase transitoire, la fréquence instantanée de l'oscillation avec freinage 114 augmente donc et les impulsions de freinage se rapprochent progressivement d'une position extrême de l'oscillation. Après un certain temps, les impulsions de freinage comprennent le passage par la position extrême où la vitesse du résonateur mécanique change de sens. Dès ce moment-là, on a un phénomène similaire à celui exposé ci-avant. Les impulsions de freinage 114a présentent alors deux parties et la seconde partie diminue la fréquence instantanée. Cette diminution de la fréquence instantanée continue jusqu'à ce qu'elle ait une valeur égale à la valeur de consigne pour de mêmes raisons que données en référence aux Figures 9 et 10. La diminution de fréquence s'arrête automatiquement lorsque la fréquence instantanée est sensiblement égale à la fréquence de consigne. On obtient alors une stabilisation de la fréquence de l'oscillateur mécanique à la fréquence de consigne dans une phase synchrone.

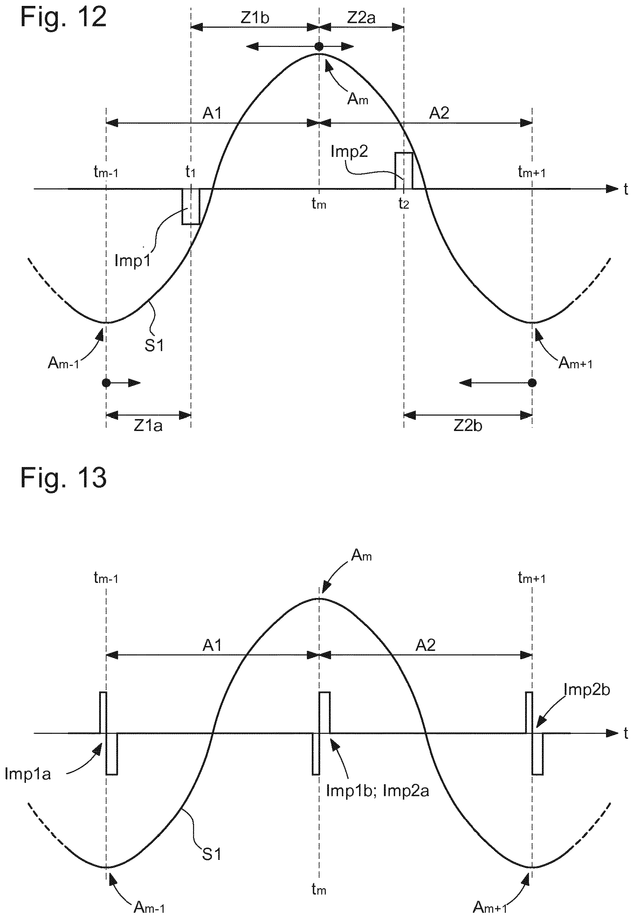

A l'aide des Figures 12 à 15, on exposera le comportement de l'oscillateur mécanique dans la phase de transition pour n'importe quel instant où intervient une première impulsion de freinage au cours d'une période d'oscillation, ainsi que la situation finale correspondant à la phase synchrone où la fréquence d'oscillation est stabilisée sur la fréquence de consigne. La Figure 12 représente une période d'oscillation avec la courbe S1 des positions d'un résonateur mécanique. Dans le cas considéré ici, la fréquence d'oscillation naturelle F0 de l'oscillateur mécanique libre (sans impulsions de freinage) est supérieure à la fréquence de consigne F0_{C} (F0 > F0_{C}). La période d'oscillation comprend classiquement une première alternance A1 suivie d'une deuxième alternance A2, chacune entre deux positions extrêmes (tₘ₋₁, Aₘ₋₁; tₘ, Aₘ ; tₘ₊₁, Aₘ₊₁) correspondant à l'amplitude d'oscillation. Ensuite, on a représenté, dans la première alternance, une impulsion de freinage 'Imp1' dont la position temporelle milieu intervient à un instant t₁ et, dans la seconde alternance, une autre impulsion de freinage 'Imp2' dont la position temporelle milieu intervient à un instant t₂. Les impulsions Imp1 et Imp2 présentent un déphasage de T0/2, et elles sont particulières car elles correspondent, pour un profil donné du couple de freinage, à des corrections engendrant deux équilibres instables du système. Comme ces impulsions interviennent respectivement dans le premier et le troisième quart de la période d'oscillation, elles freinent donc l'oscillateur mécanique dans une mesure qui permet exactement de corriger la fréquence naturelle trop élevée de l'oscillateur mécanique libre (avec la fréquence de freinage sélectionnée pour l'application des impulsions de freinage). On notera que les impulsions Imp1 et Imp2 sont toutes deux des premières impulsions, chacune étant considérée pour elle-même en l'absence de l'autre. On remarquera que les effets des impulsions Imp1 et Imp2 sont identiques.

Si une première impulsion intervient au temps t₁ ou t₂, on aura donc théoriquement une répétition de cette situation lors des prochaines périodes d'oscillation et une fréquence d'oscillation égale à la fréquence de consigne. Deux choses sont à relever pour un tel cas. Premièrement, la probabilité qu'une première impulsion intervienne exactement au temps t₁ ou t₂ est relativement faible bien que possible. Deuxièmement, au cas où une telle situation particulière se présente, elle ne pourra durer longtemps. En effet, la fréquence instantanée d'un balancier-spiral dans une pièce d'horlogerie varie un peu au cours du temps pour diverses raisons (amplitude d'oscillation, température, changement d'orientation spatiale, etc.). Bien que ces raisons constituent des perturbations qu'on cherche généralement à minimiser en haute horlogerie, il n'en demeure pas moins qu'en pratique un tel équilibre instable ne va pas durer bien longtemps. On notera que plus le couple de freinage est élevé, plus les temps t₁ et t₂ se rapprochent des deux temps de passage du résonateur mécanique par sa position neutre qui les suivent respectivement. On notera encore que plus la différence entre la fréquence d'oscillation naturelle F0 et la fréquence de consigne FOc est petite, plus les temps t₁ et t₂ se rapprochent également des deux temps de passage du résonateur mécanique par sa position neutre qui les suivent respectivement.

Considérons maintenant ce qui se passe dès qu'on s'écarte un peu des positions temporelles t₁ ou t₂ lors de l'application des impulsions. Selon l'enseignement donné en référence à la Figure 8B, si une impulsion intervient à gauche (position temporelle antérieure) de l'impulsion Imp1 dans la zone Z1a, la correction augmente de sorte qu'au cours des périodes suivantes, la position extrême précédente Aₘ₋₁ va progressivement se rapprocher de l'impulsion de freinage. Par contre, si une impulsion intervient à droite (position temporelle postérieure) de l'impulsion Imp1, à gauche de la position zéro, la correction diminue de sorte qu'au cours des périodes suivantes les impulsions dérivent vers cette position zéro où la correction devient nulle. Ensuite, l'effet de l'impulsion change et une augmentation de la fréquence instantanée intervient. Comme la fréquence naturelle est déjà trop élevée, l'impulsion va rapidement dériver vers la position extrême Aₘ. Ainsi, si une impulsion a lieu à droite de l'impulsion Imp1 dans la zone Z1b, les impulsions suivantes vont progressivement se rapprocher de la position extrême suivante Aₘ. On observe un même comportement dans la seconde alternance A2. Si une impulsion a lieu à gauche de l'impulsion Imp2 dans la zone Z2a, les impulsions suivantes vont progressivement se rapprocher de la position extrême précédente Aₘ. Par contre, si une impulsion a lieu à droite de l'impulsion Imp2 dans la zone Z2b, les impulsions suivantes vont progressivement se rapprocher de la position extrême suivante Aₘ₊₁. On remarquera que cette formulation est relative car en réalité la fréquence d'application des impulsions de freinage est imposée par l'oscillateur maître (fréquence de freinage donnée), de sorte que ce sont les périodes d'oscillation qui varient et de fait c'est la position extrême en question qui se rapproche de l'instant d'application d'une impulsion de freinage. En conclusion, si une impulsion intervient dans la première alternance A1 à un autre instant que t₁, la fréquence d'oscillation instantanée évolue dans une phase transitoire au cours des périodes d'oscillation suivantes de manière qu'une des deux positions extrêmes de cette première alternance (positions d'inversion du sens du mouvement du résonateur mécanique) s'approche progressivement des impulsions de freinage. Il en va de même pour la seconde alternance A2.

La Figure 13 montre la phase synchrone correspondant à une situation stable finale intervenant après la phase transitoire décrite ci-avant. Comme déjà exposé, dès que le passage par une position extrême intervient durant une impulsion de freinage, cette position extrême va se caler sur les impulsions de freinage pour autant que ces impulsions de freinage soient configurées (le couple de force et la durée) pour pouvoir corriger suffisamment la dérive temporelle de l'oscillateur mécanique libre au moins par une impulsion de freinage intervenant entièrement, selon le cas, juste avant ou juste après une position extrême. Ainsi, dans la phase synchrone, si une première impulsion intervient dans la première alternance A1, soit la position extrême Aₘ₋₁ de l'oscillation est calée sur les impulsions Imp1a, soit la position extrême Aₘ de l'oscillation est calée sur les impulsions Imp1b. Dans le cas d'un couple sensiblement constant, les impulsions Imp1a et Imp1b présentent chacune une première partie dont la durée est plus courte que celle de leur seconde partie, de manière à corriger exactement la différence entre la fréquence naturelle trop élevée de l'oscillateur principal esclave et la fréquence de consigne imposée par l'oscillateur auxiliaire maître. De même, dans la phase synchrone, si une première impulsion intervient dans la seconde alternance A2, soit la position extrême Aₘ de l'oscillation est calée sur les impulsions Imp2a, soit la position extrême Aₘ₊₁ de l'oscillation est calée sur les impulsions Imp2b.

On remarquera que les impulsions Imp1a, respectivement Imp1b, Imp2a et Imp2b occupent des positions temporelles relatives stables. En effet, une légère déviation à gauche ou à droite d'une de ces impulsions, dû à une perturbation externe, aura pour effet de ramener une impulsion suivante vers la position temporelle relative initiale. Ensuite, si la dérive temporelle de l'oscillateur mécanique varie durant la phase synchrone, l'oscillation va automatiquement subir un léger déphasage de sorte que le rapport entre la première partie et la seconde partie des impulsions Imp1a, respectivement Imp1b, Imp2a et Imp2b varie dans une mesure qui adapte la correction engendrée par les impulsions de freinage à la nouvelle différence de fréquence. Un tel comportement de la pièce d'horlogerie selon la présente invention est vraiment remarquable.

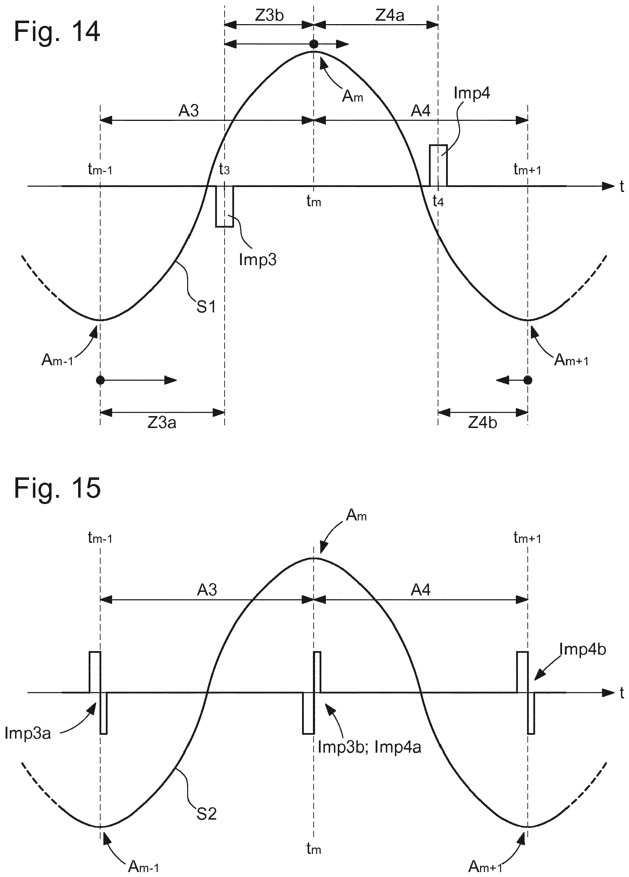

Les Figures 14 et 15 sont similaires aux Figures 12 et 13, mais pour une situation où la fréquence naturelle de l'oscillateur est inférieure à la fréquence de consigne. Par conséquent, les impulsions Imp3 et Imp4, correspondant à une situation d'équilibre instable dans la correction apportée par les impulsions de freinage, sont respectivement situées dans le deuxième et le quatrième quart de période (instants t₃ et t₄) où les impulsions engendrent une augmentation de la fréquence d'oscillation. On ne redonnera pas ici les explications en détails car le comportement du système découle des considérations précédentes. Dans la phase transitoire (Figure 14), si une impulsion a lieu dans l'alternance A3 à gauche de l'impulsion Imp3 dans la zone Z3a, la position extrême précédente (tₘ₋₁, Aₘ₋₁) va progressivement se rapprocher des impulsions suivantes. Par contre, si une impulsion a lieu à droite de l'impulsion Imp3 dans la zone Z3b, la position extrême suivante (tₘ, Aₘ) va progressivement se rapprocher des impulsions suivantes. De même, si une impulsion a lieu dans l'alternance A4 à gauche de l'impulsion Imp4 dans la zone Z4a, la position extrême précédente (tₘ, Aₘ) va progressivement se rapprocher des impulsions suivantes. Finalement, si une impulsion a lieu à droite de l'impulsion Imp4 dans la zone Z4b, la position extrême suivante (tₘ₊₁, Aₘ₊₁) va progressivement se rapprocher des impulsions suivantes durant la phase de transition.

Dans la phase synchrone (Figure 15), si une première impulsion intervient dans la première alternance A3, soit la position extrême Aₘ₋₁ de l'oscillation est calée sur les impulsions Imp3a, soit la position extrême Aₘ de l'oscillation est calée sur les impulsions Imp3b. Dans le cas d'un couple sensiblement constant, les impulsions Imp3a et Imp3b présentent chacune une première partie dont la durée est plus longue que celle de leur seconde partie, de manière à corriger exactement la différence entre la fréquence naturelle trop faible de l'oscillateur principal esclave et la fréquence de consigne imposée par l'oscillateur auxiliaire maître. De même, dans la phase synchrone, si une première impulsion intervient dans la seconde alternance A4, soit la position extrême Aₘ de l'oscillation est calée sur les impulsions Imp4a, soit la position extrême Aₘ₊₁ de l'oscillation est calée sur les impulsions Imp4b. Les autres considérations faîtes dans le cadre du cas décrit précédemment en référence aux Figures 12 et 13 s'appliquent par analogie au cas des Figures 14 et 15. En conclusion, que la fréquence naturelle de l'oscillateur mécanique libre soit trop élevée ou trop basse et quel que soit l'instant de l'application d'une première impulsion de freinage à l'intérieur d'une période d'oscillation, le dispositif de correction de l'invention est efficace et synchronise rapidement la fréquence de l'oscillateur mécanique, cadençant la marche du mouvement mécanique, sur la fréquence de consigne qui est déterminée par la fréquence de référence de l'oscillateur auxiliaire maître, lequel pilote la fréquence de freinage à laquelle les impulsions de freinage sont appliquées au résonateur de l'oscillateur mécanique. Ceci reste vrai si la fréquence naturelle de l'oscillateur mécanique varie et même si elle est, dans certaines périodes de temps, supérieure à la fréquence de consigne, alors que dans d'autres périodes de temps elle est inférieure à cette fréquence de consigne.

L'enseignement donné ci-avant et la synchronisation obtenue grâce aux caractéristiques de la pièce d'horlogerie selon l'invention s'appliquent également au cas où la fréquence de freinage pour l'application des impulsions de freinage n'est pas égale à la fréquence de consigne. Dans le cas de l'application d'une impulsion par période d'oscillation, les impulsions ayant lieu aux positions instables (t₁, Imp1 ; t₂, Imp2 ; t₃, Imp3 ; t₄, Imp4) correspondent à des corrections pour compenser la dérive temporelle au cours d'une seule période d'oscillation. Par contre, si les impulsions de freinage prévues ont un effet suffisant pour corriger une dérive temporelle au cours de plusieurs périodes d'oscillation, il est alors possible d'appliquer une seule impulsion par intervalle de temps égal à ces plusieurs périodes d'oscillation. On observera alors le même comportement que pour le cas où une impulsion est engendrée par période d'oscillation. En considérant les périodes d'oscillation où interviennent les impulsions, on a les mêmes phases transitoires et les mêmes phases synchrones que dans le cas exposé précédemment. De plus, ces considérations sont aussi correctes s'il y a un nombre entier d'alternances entre chaque impulsion de freinage. Dans le cas d'un nombre impair d'alternances, on passe alternativement, selon le cas, de l'alternance A1 ou A3 à l'alternance A2 ou A4 sur les Figures 12 à 15. Comme l'effet de deux impulsions décalées d'une alternance est identique, on comprend que la synchronisation est réalisée comme pour un nombre pair d'alternances entre deux impulsions de freinage successives. En conclusion, comme déjà indiqué, le comportement du système décrit en référence aux Figures 12 à 15 est observé dès que la fréquence de freinage F_{FR} est égale à 2F0_{C} / N, FOc étant la fréquence de consigne pour la fréquence d'oscillation et N un nombre entier positif.

Bien que peu intéressant, on remarquera que la synchronisation est aussi obtenue pour une fréquence de freinage F_{FR} supérieure au double de la fréquence de consigne (2F0), à savoir pour une valeur égale à N fois F0 avec N > 2. Dans une variante avec F_{FR} = 4F0, on ajuste une perte d'énergie dans le système sans effet dans la phase synchrone, car une impulsion sur deux intervient au point neutre du résonateur mécanique. Pour une fréquence de freinage F_{FR} plus élevée, les impulsions dans la phase synchrone qui n'interviennent pas aux positions extrêmes annulent leurs effets deux à deux. On comprend donc qu'il s'agit de cas théoriques sans grand sens pratique.

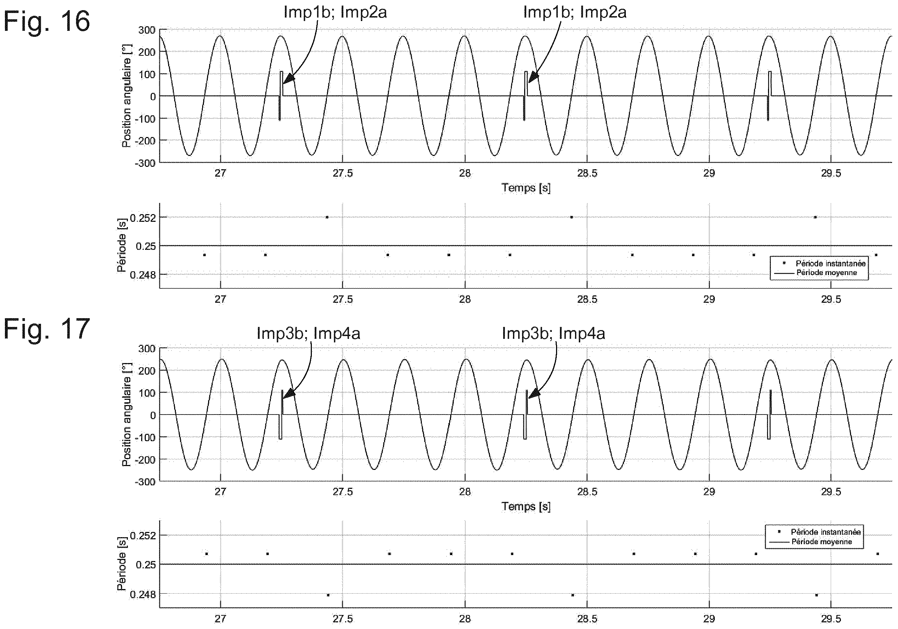

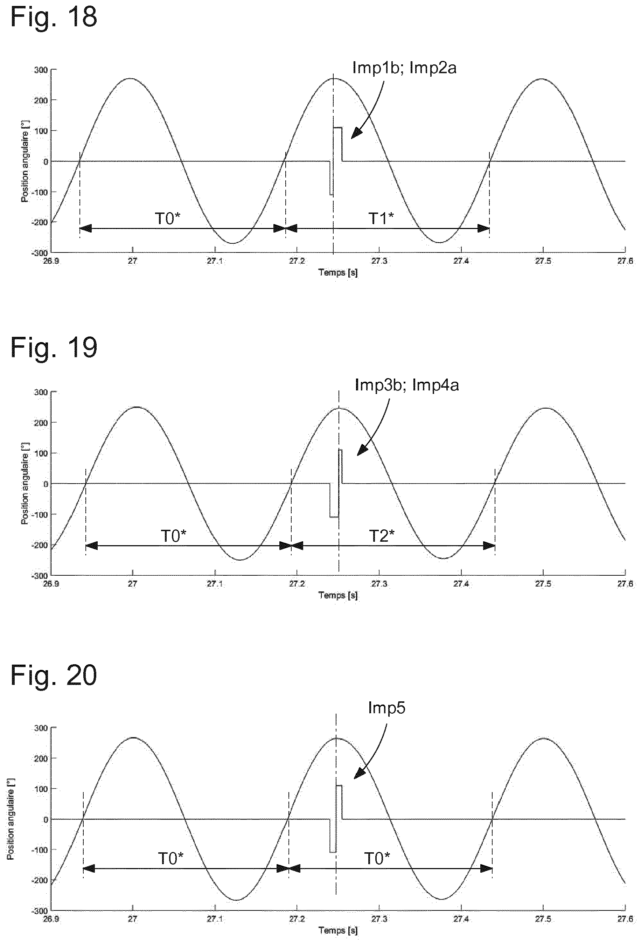

Les Figures 16 et 17 montrent la phase synchrone pour une variante avec une fréquence de freinage F_{FR} égale au quart de la fréquence de consigne, une impulsion de freinage intervenant donc toutes les quatre périodes d'oscillation. Les Figures 18 et 19 sont des agrandissements partiels respectivement des Figures 16 et 17. La Figure 16 concerne un cas où la fréquence naturelle de l'oscillateur principal est supérieure à la fréquence de consigne FOc = 4 Hz, alors que la Figure 17 concerne un cas où la fréquence naturelle de l'oscillateur principal est supérieure à cette fréquence de consigne. On observe que seules les périodes d'oscillation T1* et T2*, dans lesquelles interviennent des impulsions de freinage Imp1b ou Imp2a, respectivement Imp3b ou Imp4a, présentent une variation relativement à la période naturelle T0*. Les impulsions de freinage engendrent un déphasage seulement dans les périodes correspondantes. Ainsi, les périodes instantanées oscillent ici autour d'une valeur moyenne qui est égale à celle de la période de consigne. On notera que, aux Figures 16 à 19, les périodes instantanées sont mesurées d'un passage par zéro sur un flanc montant du signal d'oscillation à un tel passage suivant. Ainsi, les impulsions synchrones qui interviennent aux positions extrêmes sont entièrement englobées dans des périodes d'oscillation. Pour être complet, la Figure 20 montre le cas spécifique où la fréquence naturelle est égale à la fréquence de consigne. Dans ce cas, les périodes d'oscillation T0* demeurent toutes égales, les impulsions de freinage Imp5 intervenant exactement à des positions extrêmes de l'oscillation libre avec des première et seconde parties de ces impulsions qui ont des durées identiques (cas d'un couple de freinage constant), de sorte que l'effet de la première partie est annulé par l'effet opposé de la deuxième partie.

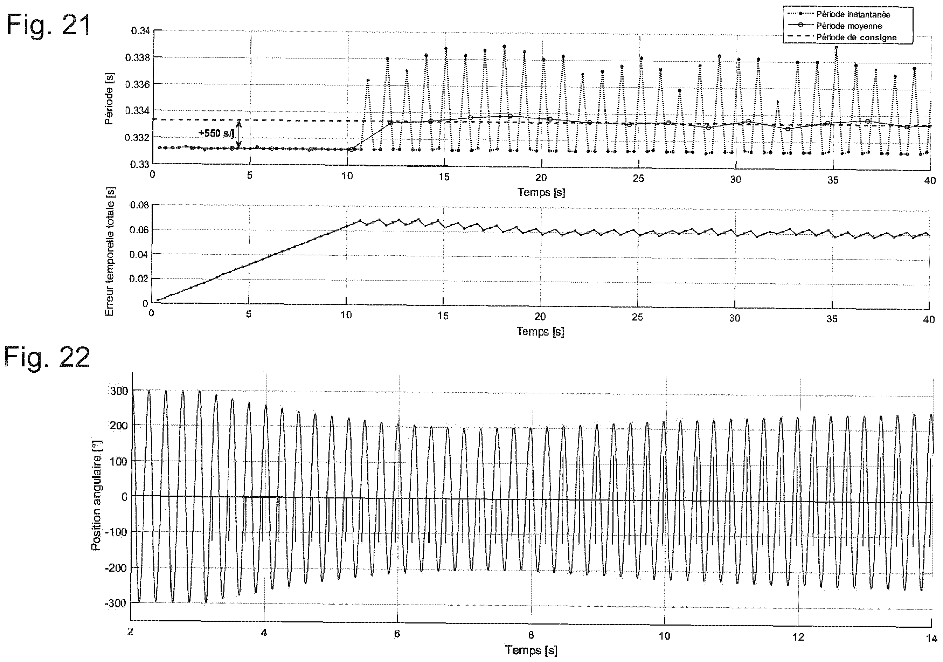

La Figure 21 montre la variation des périodes d'oscillation pour une fréquence de consigne F0_{C} = 3 Hz et une impulsion de freinage appropriée intervenant toutes les trois périodes d'oscillation de l'oscillateur mécanique qui cadence la marche d'un mécanisme indicateur de l'heure présentant une erreur journalière de 550 secondes par jour, soit environ 9 minutes par jour. Cette erreur est très importante, mais le dispositif de freinage mécanique est configuré pour permettre de corriger une telle erreur. L'effet du freinage devant être ici relativement important, on a une grande variation de la période instantanée mais la période moyenne est sensiblement égale à la période de consigne après l'enclenchement du dispositif de correction dans la pièce d'horlogerie selon l'invention et une courte phase transitoire. Lorsque le dispositif de correction est inactif, on observe, comme attendu, que l'erreur temporelle totale augmente linéairement en fonction du temps alors que cette erreur se stabilise rapidement après l'enclenchement du dispositif de correction. Ainsi, si une mise à l'heure est effectuée après un tel enclenchement du dispositif de correction et la phase transitoire, l'erreur totale (aussi nommée 'erreur cumulée') demeure faible, de sorte que la pièce d'horlogerie indique par la suite une heure avec une précision correspondant à celle de l'oscillateur maître incorporé dans cette pièce d'horlogerie et associé au dispositif de freinage.

La Figure 22 montre l'évolution de l'amplitude de l'oscillateur mécanique esclave après l'enclenchement du dispositif de correction selon l'invention. Dans la phase transitoire, on observe une diminution relativement marquée de l'amplitude dans un cas où la première impulsion a lieu proche de la position zéro (position neutre). Les diverses impulsions de freinage intervenant en particulier dans une première partie de cette phase transitoire engendrent des pertes en énergie relativement importantes, ceci découlant du graphe de la Figure 8C. Par la suite, les pertes en énergie diminuent assez rapidement pour finalement devenir minimales pour une correction donnée dans la phase synchrone. Dès lors, on observe que l'amplitude augmente à nouveau dès que les impulsions englobent le passage par une position extrême du résonateur mécanique et continue d'augmenter au début de la phase synchrone bien que l'énergie de freinage dissipée se stabilise alors à son minimum, étant donné une relativement grande constante de temps pour la variation d'amplitude de l'oscillateur mécanique. Ainsi, la pièce selon l'invention présente en plus le bénéfice de se stabiliser dans une phase synchrone pour laquelle l'énergie dissipée par l'oscillateur, du fait des impulsions de freinage prévues, est minimale. En effet, l'oscillateur présente après stabilisation de son amplitude la plus petite diminution d'amplitude possible pour les impulsions de freinage prévues. C'est un avantage car lorsque le ressort-moteur entretenant l'oscillateur principal se détend, l'amplitude d'oscillation minimale pour assurer le fonctionnement du mouvement mécanique est atteinte le plus tard possible tout en assurant une marche précise. Le dispositif de correction de la marche d'un mouvement mécanique qui engendre la synchronisation selon l'invention a donc une influence minimisée pour la réserve de marche.

Pour minimiser les perturbations engendrées par les impulsions de freinage et notamment les pertes en énergie pour le mouvement horloger, on sélectionnera de préférence de courtes durées d'impulsion, voire de très courtes durées d'impulsion. Ainsi, dans une variante générale, les impulsions de freinage ont chacune une durée comprise entre 1/400 et 1/10 de la période de consigne. Dans une variante préférée, les impulsions de freinage ont chacune une durée comprise entre 1/400 et 1/50 de ladite période de consigne. Dans ce dernier cas, pour une fréquence de consigne égale à 5 Hz, la durée des impulsions est comprise entre 0.5 ms et 4 ms.

En référence aux Figures 1 à 5, on a décrit des pièces d'horlogerie avec des résonateurs mécaniques présentant une surface de freinage circulaire permettant au dispositif de freinage d'appliquer une impulsion de freinage mécanique au résonateur mécanique sensiblement à tout instant d'une période d'oscillation dans la plage de fonctionnement utile de l'oscillateur mécanique formé par le résonateur mécanique. Ceci est une variante de réalisation préférée. Comme les mouvements horlogers ont généralement des balanciers présentant une serge circulaire avec une surface externe avantageusement continue, la variante préférée indiquée ci-dessus peut être aisément implémentée dans de tels mouvements sans nécessiter de modifications de leur oscillateur mécanique. On comprend que cette variante préférée permet de minimiser la durée de la phase de transition et d'assurer la synchronisation voulue dans le meilleur délai.

Cependant, la synchronisation stable peut déjà être obtenue, après une certaine période de temps, avec un système, formé du résonateur mécanique et du dispositif de freinage mécanique, qui est configuré de manière à permettre au dispositif de freinage mécanique de pouvoir débuter les impulsions de freinage périodiques à n'importe quelle position du résonateur mécanique seulement dans une plage continue ou quasi continue de positions de ce résonateur définie, d'un premier des deux côtés de la position neutre du résonateur mécanique, par la plage des amplitudes de l'oscillateur mécanique pour sa plage de fonctionnement utile. Avantageusement, cette plage de positions est augmentée, du côté de l'amplitude minimale, au moins par une distance angulaire correspondant sensiblement à la durée d'une impulsion de freinage, de sorte à permettre pour une amplitude minimale une impulsion de freinage par un frottement sec dynamique. Pour que le système puisse agir dans toutes les alternances et non seulement une fois par période d'oscillation, il est alors nécessaire que ce système soit configuré de manière à permettre au dispositif de freinage mécanique de pouvoir également débuter les impulsions de freinage périodiques à n'importe quelle position du résonateur mécanique du second des deux côtés de ladite position neutre, dans la plage des amplitudes de l'oscillateur mécanique pour sa plage de fonctionnement utile. Avantageusement, la plage de positions est aussi augmentée, du côté de l'amplitude minimale, au moins par une distance angulaire correspondant sensiblement à la durée d'une impulsion de freinage.

Ainsi, dans une première variante générale, la plage continue ou quasi continue susmentionnée de positions du résonateur mécanique s'étend, d'un premier des deux côtés de sa position neutre, au moins sur la plage des amplitudes que l'oscillateur mécanique esclave est susceptible d'avoir de ce premier côté pour une plage de fonctionnement utile de cet oscillateur mécanique et avantageusement en plus, du côté d'une amplitude minimale de la plage des amplitudes, au moins sur une distance angulaire correspondant sensiblement à la durée des impulsions de freinage. Dans une deuxième variante générale, en plus de la plage continue ou quasi continue définie ci-avant dans la première variante générale, laquelle est une première plage continue ou quasi continue, le système susmentionné est configuré de manière à permettre au dispositif de freinage de pouvoir aussi débuter les impulsions de freinage périodiques à n'importe quelle position du résonateur mécanique, du second des deux côtés de sa position neutre, au moins dans une deuxième plage continue ou quasi continue de positions de ce résonateur mécanique s'étendant sur la plage des amplitudes que l'oscillateur mécanique esclave est susceptible d'avoir de ce second côté pour ladite plage de fonctionnement utile et avantageusement en plus, du côté d'une amplitude minimale de cette dernière plage des amplitudes, au moins sur ladite première distance angulaire.

Dans une variante perfectionnée, le dispositif de correction est agencé de manière que la fréquence de freinage peut prendre plusieurs valeurs, de préférence une première valeur dans une phase initiale du fonctionnement du dispositif de correction et une deuxième valeur, inférieure à la première valeur, dans une phase de fonctionnement normal succédant à la phase initiale. En particulier, on sélectionnera la durée de la phase initiale de manière que la phase de fonctionnement normal intervienne alors que la phase synchrone a vraisemblablement déjà commencée. Plus généralement, la phase initiale englobe au moins les premières impulsions de freinage, suite à l'enclenchement du dispositif de correction, et de préférence la majeure partie de la phase transitoire. En augmentant la fréquence des d'impulsions de freinage, on diminue la durée de la phase transitoire. De plus, cette variante permet, d'une part, d'optimiser l'efficacité du freinage durant la phase initiale pour assurer le processus physique conduisant à la synchronisation et, d'autre part, de minimiser l'énergie de freinage et donc les pertes d'énergie pour l'oscillateur principal durant la phase synchrone qui perdure tant que le dispositif de correction n'est pas désactivé et que le mouvement mécanique fonctionne. Les premières impulsions de freinage peuvent intervenir à proximité de la position neutre du résonateur où l'effet du freinage est moindre sur le déphasage temporel engendré pour l'oscillation de l'oscillateur principal. Par contre, une fois la synchronisation établie, les impulsions de freinage ont lieu à proximité des positions extrêmes de cette oscillation où l'effet du freinage est le plus important.

Dans la phase synchrone, la situation est donc robuste et le maintien de la synchronisation s'obtient déjà avec une fréquence de freinage relativement basse. On peut donc diminuer la fréquence de freinage dans la phase synchrone tout en maintenant la synchronisation avec une bonne robustesse, notamment en cas de perturbations ou chocs que peut subir la pièce d'horlogerie. On notera que la fréquence de freinage sélectionnée peut varier aussi en fonction de divers paramètres extérieurs à l'oscillateur mécanique esclave qui peuvent être mesurés par des capteurs appropriés, notamment la valeur d'un champ magnétique ambiant, la température dans la pièce d'horlogerie ou encore la détection de chocs par un accéléromètre.

Finalement, dans le cadre de la présente invention, on peut distinguer deux catégories d'impulsions de freinage périodiques en relation avec l'intensité du couple de force mécanique appliqué au résonateur mécanique et la durée des impulsions de freinage périodiques. Concernant la première catégorie, le couple de freinage et la durée des impulsions de freinage sont prévus, pour la plage de fonctionnement utile de l'oscillateur mécanique, de manière à ne pas bloquer momentanément le résonateur mécanique au cours des impulsions de freinage périodiques au moins dans la majeure partie de la phase transitoire qui a été décrite précédemment. Dans ce cas, le système est agencé de manière que le couple de freinage mécanique est appliqué au résonateur mécanique, au moins dans la majeure partie de la phase transitoire éventuelle, durant chaque impulsion de freinage.

Dans une variante avantageuse, l'organe oscillant et l'organe de freinage sont agencés de manière que les impulsions de freinage périodiques puissent être appliquées, au moins dans ladite majeure partie de la phase transitoire éventuelle, principalement par un frottement sec dynamique entre l'organe de freinage et une surface de freinage de l'organe oscillant. Concernant la deuxième catégorie, pour la plage de fonctionnement utile de l'oscillateur mécanique et dans la phase synchrone qui a été décrite précédemment, le couple de freinage mécanique et la durée des impulsions de freinage périodiques sont prévus de manière à bloquer le résonateur mécanique au cours des impulsions de freinage périodiques au moins dans leur partie terminale.

Dans une variante particulière, il est prévu dans la phase synchrone un blocage momentané du résonateur mécanique par les impulsions de freinage périodiques alors que, au moins dans une partie initiale de la phase transitoire éventuelle où les impulsions de freinage périodiques interviennent hors des positions extrêmes du résonateur mécanique, ce dernier n'est pas bloqué par ces impulsions de freinage périodiques.

## Revendications

1. Pièce d'horlogerie (2, 34, 62, 80) comprenant un mouvement mécanique (4) qui comprend :
- un mécanisme (12) indicateur d'au moins une donnée temporelle,
- un résonateur mécanique (6, 6A) susceptible d'osciller le long d'un axe général d'oscillation autour d'une position neutre correspondant à son état d'énergie potentielle minimale,
- un dispositif (18) d'entretien du résonateur mécanique formant avec ce résonateur mécanique un oscillateur mécanique qui est agencé pour cadencer la marche du mécanisme indicateur ;
la pièce d'horlogerie comprenant en outre un dispositif (20, 36) de régulation de la fréquence moyenne de l'oscillateur mécanique, ce dispositif de régulation comprenant un dispositif de freinage mécanique du résonateur mécanique ;
**caractérisée en ce que** le dispositif de freinage mécanique (24, 38,40, 64) est agencé pour pouvoir appliquer audit résonateur mécanique un couple de freinage mécanique dissipatif durant des impulsions de freinage périodiques qui sont générées à une fréquence de freinage sélectionnée seulement en fonction d'une fréquence de consigne pour ledit oscillateur mécanique et déterminée par un oscillateur auxiliaire (22, 42) associé au dispositif de régulation, le système formé du résonateur mécanique et du dispositif de freinage mécanique étant configuré de manière à permettre au dispositif de freinage mécanique de pouvoir débuter lesdites impulsions de freinage périodiques à n'importe quelle position du résonateur mécanique dans une plage de positions, le long dudit axe général d'oscillation, qui s'étend au moins d'un premier des deux côtés de la position neutre du résonateur mécanique sur au moins une plage d'amplitudes que l'oscillateur mécanique est susceptible d'avoir de ce premier côté pour une plage de fonctionnement utile de cet oscillateur mécanique.

2. Pièce d'horlogerie selon la revendication 1, **caractérisée en ce qu'**une première partie de ladite plage de positions du résonateur mécanique, incorporant ladite plage d'amplitudes que l'oscillateur mécanique est susceptible d'avoir dudit premier côté de la position neutre du résonateur mécanique, présente une certaine étendue sur laquelle elle est continue ou quasi continue, cette première partie s'étendant, du côté d'une amplitude minimale de ladite plage d'amplitudes, au moins sur une distance angulaire correspondant sensiblement à la durée d'une desdites impulsions de freinage périodique pour cette amplitude minimale.

3. Pièce d'horlogerie selon la revendication 1 ou 2, **caractérisée en ce que** ledit système est configuré de manière que ladite plage de positions du résonateur mécanique, dans laquelle peuvent débuter lesdites impulsions de freinage périodiques, s'étend également du second des deux côtés de la position neutre du résonateur mécanique sur au moins une plage d'amplitudes que l'oscillateur mécanique est susceptible d'avoir de ce second côté pour ladite plage de fonctionnement utile de cet oscillateur mécanique.

4. Pièce d'horlogerie selon la revendication 3, **caractérisée en ce qu'**une deuxième partie de ladite plage de positions du résonateur mécanique, incorporant ladite plage des amplitudes que l'oscillateur mécanique est susceptible d'avoir dudit second côté de la position neutre du résonateur mécanique, présente une certaine étendue sur laquelle elle est continue ou quasi continue, cette deuxième partie s'étendant, du côté d'une amplitude minimale de la plage d'amplitudes que l'oscillateur mécanique est susceptible d'avoir du second côté de ladite position neutre, au moins sur une distance angulaire correspondant sensiblement à la durée d'une desdites impulsions de freinage périodique pour cette amplitude minimale.

5. Pièce d'horlogerie selon une quelconque des revendications précédentes, **caractérisée en ce que** ladite fréquence de freinage est prévue égale au double de ladite fréquence de consigne divisée par un nombre entier positif N, soit F_{FR} = 2-F0_{C} / N où F_{FR} est la fréquence de freinage et F0_{C} est la fréquence de consigne.

6. Pièce d'horlogerie selon une quelconque des revendications précédentes, **caractérisée en ce que** ledit oscillateur auxiliaire est incorporé dans cette pièce d'horlogerie.

7. Pièce d'horlogerie selon une quelconque des revendications précédentes, **caractérisée en ce que** le dispositif de freinage mécanique est agencé pour pouvoir appliquer audit résonateur mécanique ledit couple de freinage mécanique dissipatif substantiellement par frottement et de manière que lesdites impulsions de freinage périodiques ont chacune essentiellement une durée inférieure au quart de la période de consigne correspondant à l'inverse de la fréquence de consigne.

8. Pièce d'horlogerie selon une quelconque des revendications 1 à 6, **caractérisée en ce que** le dispositif de freinage mécanique est agencé pour pouvoir appliquer audit résonateur mécanique ledit couple de freinage mécanique dissipatif substantiellement par frottement et de manière que les impulsions de freinage périodiques ont chacune essentiellement une durée comprise entre 1/400 et 1/10 de la période de consigne correspondant à l'inverse de la fréquence de consigne.

9. Pièce d'horlogerie selon une quelconque des revendications 1 à 6, **caractérisée en ce que** ledit dispositif de freinage mécanique est agencé pour pouvoir appliquer audit résonateur mécanique ledit couple de freinage mécanique dissipatif substantiellement par frottement et de manière que les impulsions de freinage périodiques ont chacune essentiellement une durée comprise entre 1/400 et 1/50 de la période de consigne correspondant à l'inverse de la fréquence de consigne.

10. Pièce d'horlogerie selon une quelconque des revendications précédentes, **caractérisée en ce que** ledit système est configuré de manière à permettre au dispositif de freinage mécanique (24, 38,40, 64) de débuter, dans ladite plage de fonctionnement utile dudit oscillateur mécanique, une desdites impulsions de freinage périodiques à n'importe quelle position du résonateur mécanique le long dudit axe général d'oscillation.

11. Pièce d'horlogerie selon la revendication 10, **caractérisée en ce que** le dispositif de freinage mécanique comprend un organe de freinage (41, 41A,41B, 90) qui est agencé pour être actionné à ladite fréquence de freinage par le dispositif de régulation, de manière à exercer sur un organe oscillant (8, 8A) dudit résonateur mécanique (6, 6A) ledit couple de freinage mécanique dissipatif durant lesdites impulsions de freinage périodiques.

12. Pièce d'horlogerie selon la revendication 11, **caractérisée en ce que** ledit oscillateur auxiliaire (42) est du type électrique ; et **en ce que** le dispositif de freinage mécanique est formé par un actionneur électromécanique (38, 66,68, 86) qui actionne ledit organe de freinage, cet actionneur électromécanique comprenant un élément piézoélectrique ou un élément magnétostrictif ou, pour actionner ledit organe de freinage, un système électromagnétique.

13. Pièce d'horlogerie selon la revendication 11 ou 12, **caractérisée en ce que** ledit couple de freinage mécanique dissipatif et la durée des impulsions de freinage périodiques sont prévus, dans la plage de fonctionnement utile dudit oscillateur mécanique, de manière à ne pas bloquer momentanément ledit résonateur mécanique au cours des impulsions de freinage périodiques au moins dans la majeure partie d'une phase transitoire éventuelle du fonctionnement de la pièce d'horlogerie, cette phase transitoire pouvant intervenir, notamment suite à un enclenchement du dispositif de régulation, avant une phase synchrone où ledit oscillateur mécanique est synchronisé sur les impulsions de freinage périodiques.

14. Pièce d'horlogerie selon la revendication 13, **caractérisée en ce que** l'organe oscillant et l'organe de freinage sont agencés de manière que les impulsions de freinage périodiques puissent être appliquées, au moins dans ladite majeure partie de ladite phase transitoire éventuelle, principalement par un frottement sec dynamique entre l'organe de freinage (41, 41A,41B, 90) et une surface de freinage (32, 32A) de l'organe oscillant.

15. Pièce d'horlogerie selon la revendication 13 ou 14, **caractérisée en ce que**, dans la plage de fonctionnement utile de l'oscillateur mécanique et dans la phase synchrone du fonctionnement de la pièce d'horlogerie, ledit couple de freinage mécanique dissipatif et la durée des impulsions de freinage périodiques sont prévus de manière à bloquer momentanément le résonateur mécanique au cours des impulsions de freinage périodiques.

16. Pièce d'horlogerie selon une quelconque des revendications 11 à 15, **caractérisée en ce que** ledit couple de freinage mécanique dissipatif appliqué audit organe oscillant est sensiblement constant durant les impulsions de freinage périodiques.

17. Pièce d'horlogerie selon une quelconque des revendications précédentes, **caractérisée en ce que** ledit dispositif de régulation est agencé de manière que ladite fréquence de freinage peut prendre successivement plusieurs valeurs, une première valeur dans une phase initiale du fonctionnement du dispositif de régulation et une deuxième valeur, inférieure à la première valeur, dans une phase de fonctionnement normal succédant à la phase initiale.

18. Module de synchronisation d'un oscillateur mécanique que comprend une pièce d'horlogerie et qui cadence la marche d'un mécanisme horloger de cette pièce d'horlogerie, ce module de synchronisation étant destiné à être incorporé dans la pièce d'horlogerie pour synchroniser l'oscillateur mécanique sur un oscillateur auxiliaire (22, 42) incorporé dans le module de synchronisation ; **caractérisé en ce qu'**il comprend un dispositif (24, 38,40, 64) de freinage mécanique d'un résonateur mécanique formant ledit oscillateur mécanique, ce dispositif de freinage mécanique étant agencé pour pouvoir appliquer au résonateur mécanique un couple de freinage mécanique dissipatif durant des impulsions de freinage périodiques qui sont générées à une fréquence de freinage sélectionnée seulement en fonction d'une fréquence de consigne pour ledit oscillateur mécanique et déterminée par l'oscillateur auxiliaire, le dispositif de freinage mécanique étant configuré de manière à pouvoir débuter les impulsions de freinage périodiques à n'importe quelle position du résonateur mécanique dans une plage de positions, le long d'un axe général d'oscillation, qui s'étend au moins des deux côtés de la position neutre du résonateur mécanique sur respectivement au moins deux plages d'amplitudes que l'oscillateur mécanique est susceptible d'avoir respectivement de ces deux côtés pour une plage de fonctionnement utile de cet oscillateur mécanique.

19. Module de synchronisation selon la revendication 18, **caractérisé en ce que** le dispositif de freinage mécanique comprend un organe de freinage (41, 41A,41B, 90) qui est agencé pour être actionné à ladite fréquence de freinage de manière à pouvoir venir momentanément en contact avec un organe oscillant (8, 8A) dudit résonateur mécanique (6, 6A) pour exercer ledit couple de freinage mécanique dissipatif sur cet organe oscillant durant lesdites impulsions de freinage périodiques.

20. Module de synchronisation selon la revendication 19, **caractérisé en ce que** l'organe de freinage est agencé de manière que les impulsions de freinage périodiques puissent être appliquées audit organe oscillant, au moins dans une majeure partie d'une phase transitoire éventuelle pouvant intervenir notamment après une activation du module de synchronisation, principalement par un frottement sec dynamique entre l'organe de freinage et une surface de freinage (32, 32A) de l'organe oscillant.

## Patentansprüche

1. Uhr (2, 34, 62, 80), die ein mechanisches Werk (4) umfasst, das Folgendes umfasst:
- einen Mechanismus (12) zur Anzeige mindestens eines Zeitdatums,
- einen mechanischen Resonator (6, 6A), der in der Lage ist, entlang einer allgemeinen Oszillationsachse um eine neutrale Position herum zu oszillieren, die seinem potenziellen Mindestenergiezustand entspricht,
- eine Vorrichtung (18) zur Instandhaltung des mechanischen Resonators, die mit diesem mechanischen Resonator einen mechanischen Oszillator bildet, der angeordnet ist, um den Gang des Mechanismus zur Anzeige zu rhythmisieren;
wobei die Uhr weiter eine Vorrichtung (20, 36) zum Regeln der mittleren Frequenz des mechanischen Oszillators umfasst, wobei diese Vorrichtung zum Regeln eine mechanische Bremsvorrichtung des mechanischen Resonators umfasst;
**dadurch gekennzeichnet, dass** die mechanische Bremsvorrichtung (24, 38, 40, 64) angeordnet ist, um während der periodischen Bremsimpulse, die mit einer Bremsfrequenz erzeugt werden, die nur in Abhängigkeit von einer Vorgabefrequenz für den mechanischen Oszillator und durch einen Hilfsoszillator (22, 42), der der Vorrichtung zum Regeln zugeordnet ist, an den mechanischen Resonator ein dissipatives mechanisches Bremsmoment anzulegen, wobei das durch den mechanischen Resonator und die mechanische Bremsvorrichtung gebildete System konfiguriert ist, um es der mechanischen Bremsvorrichtung zu ermöglichen, mit den periodischen Bremsimpulsen in irgendeiner Position des mechanischen Resonators in einem Bereich von Positionen entlang der allgemeinen Oszillationsachse beginnen zu können, die sich mindestens von einer ersten der beiden Seiten der neutralen Position des mechanischen Resonators über mindestens einen Bereich von Amplituden erstreckt, die der mechanische Oszillator von dieser ersten Seite für einen Nutzbetriebsbereich dieses mechanischen Oszillators in der Lage ist, aufzuweisen.

2. Uhr nach Anspruch 1, **dadurch gekennzeichnet, dass** ein erster Teil des Bereichs von Positionen des mechanischen Resonators, der den Bereich von Amplituden einbezieht, den der mechanische Oszillator von der ersten Seite der neutralen Position des mechanischen Resonators in der Lage ist aufzuweisen, eine bestimmte Ausdehnung aufweist, auf der er kontinuierlich oder quasi kontinuierlich ist, wobei sich dieser erste Teil auf Seiten einer Mindestamplitude des Bereichs von Amplituden, mindestens über einen Winkelabstand erstreckt, der im Wesentlichen der Dauer eines der periodischen Bremsimpulse für diese Mindestamplitude entspricht.

3. Uhr nach Anspruch 1 oder 2, **dadurch gekennzeichnet, dass** das System derart konfiguriert ist, dass sich der Bereich von Positionen des mechanischen Resonators, in dem die periodischen Bremsimpulse beginnen können, auch von der zweiten der beiden Seiten der neutralen Position des mechanischen Resonators auf mindestens einem Bereich von Amplituden erstreckt, den der mechanische Oszillator von dieser zweiten Seite für den Nutzbetriebsbereich dieses mechanischen Oszillators in der Lage ist aufzuweisen.

4. Uhr nach Anspruch 3, **dadurch gekennzeichnet, dass** ein zweiter Teil des Bereichs von Positionen des mechanischen Resonators, der den Bereich der Amplituden einbezieht, den der mechanische Oszillator von der zweiten Seite der neutralen Position des mechanischen Resonators in der Lage ist aufzuweisen, eine bestimmte Ausdehnung aufweist, auf der er kontinuierlich oder quasi kontinuierlich ist, wobei sich dieser zweite Teil auf Seiten einer Mindestamplitude des Bereichs von Amplituden erstreckt, den der mechanische Oszillator von der zweiten Seite der neutralen Position mindestens auf einem Winkelabstand in der Lage ist aufzuweisen, der im Wesentlichen der Dauer eines der periodischen Bremsimpulse für diese Mindestamplitude entspricht.

5. Uhr nach einem der vorstehenden Ansprüche, **dadurch gekennzeichnet, dass** die Bremsfrequenz gleich oder doppelt so groß wie die Vorgabefrequenz geteilt durch eine positive ganze Zahl N, also F_{FR} = 2·F0_{c}/N vorgesehen ist, wobei F_{FR} die Bremsfrequenz ist und F0_{c} die Vorgabefrequenz ist.

6. Uhr nach einem der vorstehenden Ansprüche, **dadurch gekennzeichnet, dass** der Hilfsoszillator in diese Uhr einbezogen ist.

7. Uhr nach einem der vorstehenden Ansprüche, **dadurch gekennzeichnet, dass** die mechanische Bremsvorrichtung angeordnet ist, um an den mechanischen Resonator das dissipative mechanische Bremsmoment im Wesentlichen durch Reibung und derart anzulegen, dass die periodischen Bremsimpulse jeweils im Wesentlichen eine Dauer von weniger als dem Viertel des Vorgabezeitraums aufweisen, der der umgekehrten Vorgabefrequenz entspricht.

8. Uhr nach einem der Ansprüche 1 bis 6, **dadurch gekennzeichnet, dass** die mechanische Bremsvorrichtung angeordnet ist, um an dem mechanischen Resonator das dissipative mechanische Bremsmoment im Wesentlichen durch Reibung und derart anzulegen, dass die periodischen Bremsimpulse jeweils im Wesentlichen eine Dauer aufweisen, die zwischen 1/400 und 1/10 des Vorgabezeitraums enthalten ist, der der umgekehrten Vorgabefrequenz entspricht.

9. Uhr nach einem der Ansprüche 1 bis 6, **dadurch gekennzeichnet, dass** die mechanische Bremsvorrichtung angeordnet ist, um an dem mechanischen Resonator das dissipative mechanische Bremsmoment im Wesentlichen durch Reibung und derart anzulegen, dass die periodischen Bremsimpulse jeweils im Wesentlichen eine Dauer aufweisen, die zwischen 1/400 und 1/50 des Vorgabezeitraums enthalten ist, der der umgekehrten Vorgabefrequenz entspricht.

10. Uhr nach einem der vorstehenden Ansprüche, **dadurch gekennzeichnet, dass** das System konfiguriert ist, um es der mechanischen Bremsvorrichtung (24, 38, 40, 64) zu ermöglichen, in dem Nutzbetriebsbereich des mechanischen Oszillators eine der periodischen Bremsimpulse in irgendeiner Position des mechanischen Resonators entlang der allgemeinen Oszillationsachse zu beginnen.

11. Uhr nach Anspruch 10, **dadurch gekennzeichnet, dass** die mechanische Bremsvorrichtung ein Bremsorgan (41, 41A, 41B, 90) umfasst, das angeordnet ist, um durch die Vorrichtung zum Regeln mit der Bremsfrequenz betätigt zu werden, um auf ein oszillierendes Organ (8, 8A) des mechanischen Resonators (6, 6A) während der periodischen Bremsimpulse das dissipative mechanische Bremsmoment auszuüben.

12. Uhr nach Anspruch 11, **dadurch gekennzeichnet, dass** der Hilfsoszillator (42) vom elektrischen Typ ist; und dadurch, dass die mechanische Bremsvorrichtung durch ein elektromechanisches Wirkglied (38, 66, 68, 86) gebildet wird, das das Bremsorgan betätigt, wobei dieses elektromechanische Wirkglied ein piezoelektrisches Element oder ein magnetrestriktives Element umfasst, oder zum Betätigen des Bremsorgans, ein elektromagnetisches System.

13. Uhr nach Anspruch 11 oder 12, **dadurch gekennzeichnet, dass** das dissipative mechanische Bremsmoment und die Dauer der periodischen Bremsimpulse in dem Nutzbetriebsbereich des mechanischen Oszillators derart vorgesehen sind, um den mechanischen Resonator im Laufe der periodischen Bremsimpulse mindestens im Hauptteil einer eventuellen Übergangsphase des Betriebs der Uhr nicht vorübergehend zu blockieren, wobei diese Übergangsphase insbesondere nach einem Einrücken der Vorrichtung zum Regeln vor einer synchronen Phase eintreten kann, in der der mechanische Oszillator mit den periodischen Bremsimpulsen synchronisiert wird.

14. Uhr nach Anspruch 13, **dadurch gekennzeichnet, dass** das oszillierende Organ und das Bremsorgan derart angeordnet sind, dass die periodischen Bremsimpulse mindestens im Hauptteil der eventuellen Übergangsphase in erster Linie durch eine dynamische trockene Reibung zwischen dem Bremsorgan (41, 41A, 41B, 90) und einer Bremsoberfläche (32, 32A) des oszillierenden Organs angewandt werden können.

15. Uhr nach Anspruch 13 oder 14, **dadurch gekennzeichnet, dass** in dem Nutzbetriebsbereich des mechanischen Oszillators und in der synchronen Phase des Betriebs der Uhr das dissipative mechanische Bremsmoment und die Dauer der periodischen Bremsimpulse derart vorgesehen sind, um den mechanischen Resonator im Laufe der periodischen Bremsimpulse vorübergehend zu blockieren.

16. Uhr nach einem der Ansprüche 11 bis 15, **dadurch gekennzeichnet, dass** das dissipative mechanische Bremsmoment, das an das oszillierende Organ angelegt wird, während der periodischen Bremsimpulse im Wesentlichen konstant ist.

17. Uhr nach einem der vorstehenden Ansprüche, **dadurch gekennzeichnet, dass** die Vorrichtung zum Regeln derart angeordnet ist, dass die Bremsfrequenz nacheinander mehrere Werte annehmen kann, einen ersten Wert in einer anfänglichen Phase des Betriebs der Vorrichtung zum Regeln, und einen zweiten Wert, kleiner als der erste Wert, in einer normalen Betriebsphase, die auf die anfängliche Phase folgt.

18. Synchronisierungsmodul eines mechanischen Oszillators, den eine Uhr umfasst, und der den Gang eines Uhrmechanismus dieser Uhr rhythmisiert, wobei dieses Synchronisierungsmodul dazu bestimmt ist, in die Uhr eingebaut zu werden, um den mechanischen Oszillator mit einem Hilfsoszillator (22, 42), der in dem Synchronisierungsmodul eingebaut ist, zu synchronisieren; **dadurch gekennzeichnet, dass** es eine mechanische Bremsvorrichtung (24, 38, 40, 64) eines mechanischen Resonators umfasst, der den mechanischen Oszillator bildet, wobei diese mechanische Bremsvorrichtung angeordnet ist, um während periodischer Bremsimpulse, die mit einer Bremsfrequenz erzeugt werden, die nur in Abhängigkeit von einer Vorgabefrequenz für den mechanischen Oszillator und durch den Hilfsoszillator bestimmt wird, an den mechanischen Resonator ein dissipatives mechanisches Bremsmoment anzulegen, wobei die mechanische Bremsvorrichtung derart konfiguriert ist, um die periodischen Bremsimpulse in irgendeiner Position des mechanischen Resonators in einem Bereich von Positionen entlang einer allgemeinen Oszillationsachse zu beginnen, die sich mindestens von den beiden Seiten der neutralen Position des mechanischen Resonators über jeweils mindestens zwei Bereiche von Amplituden erstreckt, die der mechanische Oszillator jeweils von diesen beiden Seiten für einen Nutzbetriebsbereich dieses mechanischen Oszillators in der Lage ist, aufzuweisen.

19. Synchronisierungsmodul nach Anspruch 18, **dadurch gekennzeichnet, dass** die mechanische Bremsvorrichtung ein Bremsorgan (41, 41A, 41B, 90) umfasst, das angeordnet ist, um mit der Bremsfrequenz derart betätigt zu werden, um vorübergehend in Kontakt mit einem oszillierenden Organ (8, 8A) des mechanischen Resonators (6, 6A) zu kommen, um das dissipative mechanische Bremsmoment während der periodischen Bremsimpulse auf dieses oszillierende Organ auszuüben.

20. Synchronisierungsmodul nach Anspruch 19, **dadurch gekennzeichnet, dass** das Bremsorgan derart angeordnet ist, dass die periodischen Bremsimpulse mindestens in einem Hauptteil einer eventuellen Übergangsphase an das oszillierende Organ angelegt werden können, die insbesondere nach einer Aktivierung des Synchronisierungsmoduls in erster Linie durch eine dynamische trockene Reibung zwischen dem Bremsorgan und einer Bremsoberfläche (32, 32A) des oszillierenden Organs eintreten kann.

## Claims

1. Timepiece (2, 34, 62, 80) comprising a mechanical movement (4) which comprises:
- an indicator mechanism (12) of at least one time data item,
- a mechanical resonator (6, 6A) suitable for oscillating along a general oscillation axis about a neutral position corresponding to the minimum potential energy state thereof,
- a maintenance device (18) of the mechanical resonator forming therewith a mechanical oscillator which is arranged to time the running of the indicator mechanism;
the timepiece further comprising a device (20, 36) for regulating the medium frequency of the mechanical oscillator, this regulation device comprising a mechanical braking device of the mechanical resonator;
**characterised in that** the mechanical braking device (24, 38,40, 64) is arranged to be able to apply to said mechanical resonator a dissipative mechanical braking torque during periodic braking pulses which are generated at a braking frequency selected merely as a function of a set-point frequency for said mechanical oscillator and determined by an auxiliary oscillator (22, 42) associated with the regulation device, the system formed of the mechanical resonator and the mechanical braking device being configured so as to enable the mechanical braking device to be able to start said periodic braking pulses at any position of the mechanical resonator in a range of positions, along said general oscillation axis, which extends at least on a first of the two sides from the neutral position of the mechanical resonator over at least a range of amplitudes that the mechanical oscillator is liable to have on this first side for a usable operating range of this mechanical oscillator.

2. Timepiece according to claim 1, **characterised in that** a first part of said range of positions of the mechanical resonator, incorporating said range of amplitudes that the mechanical oscillator is liable to have on said first side from the neutral position of the mechanical resonator, has a certain range whereon it is continuous or quasi-continuous, this first part extending, on the side of a minimal amplitude of said range of amplitudes, at least over an angular distance corresponding substantially to the duration of one of said periodic braking pulses for this minimal amplitude.

3. Timepiece according to claim 1 or 2, **characterised in that** said system is configured such that said range of positions of the mechanical resonator, wherein said periodic braking pulses may start, also extends on the second of the two sides from the neutral position of the mechanical resonator over at least a range of amplitudes that the mechanical oscillator is liable to have on this second side for the usable operating range of this mechanical oscillator.

4. Timepiece according to claim 3, **characterised in that** a second part of said range of positions of the mechanical resonator, incorporating said range of amplitudes that the mechanical oscillator is liable to have on said second side from the neutral position of the mechanical resonator, has a certain range whereon it is continuous or quasi-continuous, this second part extending, on the side of a minimal amplitude of the range of amplitudes that the mechanical oscillator is liable to have on the second side from said neutral position, at least over an angular distance corresponding substantially to the duration of one of said periodic braking pulses for this minimal amplitude.

5. Timepiece according to any one of the preceding claims, **characterised in that** said braking frequency is envisaged equal to double said set-point frequency divided by a positive whole number N, i.e. F_{FR} = 2.F0c/ N where F_{FR} is the braking frequency and F0c is the set-point frequency.

6. Timepiece according to any one of the preceding claims, **characterised in that** said auxiliary oscillator is incorporated in this timepiece.

7. Timepiece according to any one of the preceding claims, **characterised in that** the mechanical braking device is arranged to be able to apply to said mechanical resonator said dissipative mechanical braking torque substantially by friction and such that said periodic braking pulses each have essentially a duration less than one quarter of the set-point period corresponding to the reciprocal of the set-point frequency.

8. Timepiece according to any one of claims 1 to 6, **characterised in that** the mechanical braking device is arranged to be able to apply to said mechanical resonator said dissipative mechanical braking torque substantially by friction and such that the periodic braking pulses each have essentially a duration between 1/400 and 1/10 of the set-point period corresponding to the reciprocal of the set-point frequency.

9. Timepiece according to any one of claims 1 to 6, **characterised in that** the mechanical braking device is arranged to be able to apply to said mechanical resonator said dissipative mechanical braking torque substantially by friction and such that the periodic braking pulses each have essentially a duration between 1/400 and 1/50 of the set-point period corresponding to the reciprocal of the set-point frequency.

10. Timepiece according to any one of the preceding claims, **characterised in that** said system is configured so as to enable the mechanical braking device (24, 38,40, 64) to start, in said usable operating range of said mechanical oscillator, one of said periodic braking pulses at any position of the mechanical resonator along said general oscillation axis.

11. Timepiece according to claim 10, **characterised in that** the mechanical braking device comprises a braking member (41, 41A, 41B, 90) which is arranged to be actuated at said braking frequency by the regulation device, so as to apply to an oscillating member (8, 8A) of said mechanical resonator (6, 6A) said dissipative mechanical braking torque during said periodic braking pulses.

12. Timepiece according to claim 11, **characterised in that** said auxiliary oscillator (42) is of the electric type; and **in that** the mechanical braking device is formed by an electromechanical actuator (38, 66,68, 86) which actuates said braking member, this electromechanical actuator comprising a piezoelectric element or a magneto-resistive element or, to actuate said braking member, an electromagnetic system.

13. Timepiece according to claim 11 or 12, **characterised in that** said dissipative mechanical braking torque and the duration of the periodic braking pulses are envisaged, in the usable operating range of said mechanical oscillator, so as not to lock momentarily said mechanical resonator during the periodic braking pulses at least in most of any transitory phase of the operation of the timepiece, this transitory phase being liable to occur, particularly following an engagement of the regulation device, before a synchronous phase where said mechanical oscillator is synchronised on the periodic braking pulses.

14. Timepiece according to claim 13, **characterised in that** the oscillating member and the braking member are arranged such that the periodic braking pulses can be applied, at least said most of said any transitory phase, essentially by dynamic dry friction between the braking member (41, 41A, 41B, 90) and a braking surface (32, 32A) of the oscillating member.

15. Timepiece according to claim 13 or 14, **characterised in that**, in the usable operating range of the mechanical oscillator and in the synchronous phase of the operation of the timepiece, said dissipative mechanical braking torque and the duration of the periodic braking pulses are envisaged so as to lock the mechanical resonator momentarily during the periodic braking pulses.

16. Timepiece according to any one of claims 11 to 15, **characterised in that** said dissipative mechanical braking torque applied to said oscillating member is substantially constant during the periodic braking pulses.

17. Timepiece according to any one of the preceding claims, **characterised in that** said regulation device is arranged such that said braking frequency may adopt successively a plurality of values, a first value in an initial phase of the operation of the regulation device and a second value, less than the first value, in a normal operating phase following the initial phase.

18. Synchronisation module of a mechanical oscillator comprised by a timepiece and which times the running of a timepiece mechanism of this timepiece, this synchronisation module being intended to be incorporated in the timepiece to synchronise the mechanical oscillator on an auxiliary oscillator (22, 42) incorporated in the synchronisation module; **characterised in that** it comprises a mechanical braking device (24, 38,40, 64) of a mechanical resonator forming said mechanical oscillator, this mechanical braking device being arranged to be able to apply to the mechanical resonator a dissipative mechanical braking torque during periodic braking pulses which are generated at a braking frequency selected merely as a function of a set-point frequency for said mechanical oscillator and determined by the auxiliary oscillator, the mechanical braking device being configured so as to be able to start the periodic braking pulses at any position of the mechanical resonator in a range of positions, along a general oscillation axis, which extends at least on the two sides from the neutral position of the mechanical resonator over respectively at least two ranges of amplitudes that the mechanical oscillator is liable to have on these two sides for a usable operating range of this mechanical oscillator.

19. Synchronisation module according to claim 18, **characterised in that** the mechanical braking device comprises a braking member (41, 41A, 41B, 90) which is arranged to be actuated at said braking frequency so as to be able to come momentarily in contact with an oscillating member (8, 8A) of said mechanical resonator (6, 6A) to apply said dissipative mechanical braking torque to this oscillating member during said periodic braking pulses.

20. Synchronisation module according to claim 19, **characterised in that** the braking member is arranged such that the periodic braking pulses can be applied to said oscillating member, at least in most of any transitory phase liable to occur particularly after an activation of the synchronisation module, essentially by dynamic dry friction between the braking member and a braking surface (32, 32A) of the oscillating member.
